(19) **Europäisches Patentamt / European Patent Office / Office européen des brevets**

(11) **EP 4 416 515 B1**

(12) # FASCICULE DE BREVET EUROPEEN

(45) Date de publication et mention de la délivrance du brevet:
**29.10.2025 Bulletin 2025/44**

(21) Numéro de dépôt: **22776996.5**

(22) Date de dépôt: **30.08.2022**

(51) Classification Internationale des Brevets (IPC):
**G01R 31/26** *(2020.01)*

(52) Classification Coopérative des Brevets (CPC):
**G01R 31/2621; G01R 31/2648;** G01R 31/2639

(86) Numéro de dépôt international:
**PCT/IB2022/058094**

(87) Numéro de publication internationale:
**WO 2023/062452 (20.04.2023 Gazette 2023/16)**

(54) **PROCÉDÉ DE CARACTÉRISATION EN MODE IMPULSIONNEL D'UN TRANSISTOR À SEMI-CONDUCTEUR III-V ET BANC DE MESURES ASSOCIÉ**

VERFAHREN ZUR CHARAKTERISIERUNG EINES III-V-HALBLEITERTRANSISTORS IM IMPULSMODUS UND ZUGEHÖRIGES PRÜFBETT

METHOD FOR CHARACTERIZING IN PULSE MODE A III-V SEMICONDUCTOR TRANSISTOR AND ASSOCIATED TEST BED

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.10.2021 FR 2110920**

(43) Date de publication de la demande:
**21.08.2024 Bulletin 2024/34**

(73) Titulaire: **AMCAD Engineering**
**87280 Limoges (FR)**

(72) Inventeurs:
- **CHARBONNIAUD, Christophe**
  **19350 Chabrignac (FR)**
- **LABROUSSE, Nicolas**
  **87700 Aixe-Sur-Vienne (FR)**
- **FAURE, Maxime**
  **87100 Limoges (FR)**

(74) Mandataire: **Cabinet Netter**
**36, avenue Hoche**
**75008 Paris (FR)**

(56) Documents cités:
- NAKKALA POORNAKARTHIK: "Pulsed I-V and RF characterization and modeling of AlGaN HEMTs and Graphene FETs", 18 June 2015 (2015-06-18), pages 1 - 191, XP055922087, Retrieved from the Internet <URL:https://tel.archives-ouvertes.fr/tel-01175525/document> [retrieved on 20220517]
- GIBIINO GIAN PIERO ET AL: "Double-pulse characterization of GaN-on-Sapphire FETs for technology development", 2016 21ST INTERNATIONAL CONFERENCE ON MICROWAVE, RADAR AND WIRELESS COMMUNICATIONS (MIKON), IEEE, 9 May 2016 (2016-05-09), pages 1 - 4, XP032912966, DOI: 10.1109/MIKON.2016.7492072
- GIBIINO GIAN PIERO ET AL: "Isotrap Pulsed $IV$ Characterization of GaN HEMTs for PA Design", vol. 28, no. 8, 31 August 2018 (2018-08-31), US, pages 672 - 674, XP055921695, ISSN: 1531-1309, Retrieved from the Internet <URL:https://ieeexplore.ieee.org/stampPDF/getPDF.jsp?tp=&arnumber=8386841&ref=aHR0cHM6Ly93d3cuZ29vZ2xlLmNvbS8=> [retrieved on 20220516], DOI: 10.1109/LMWC.2018.2843278

**EP 4 416 515 B1**

**Description**

La présente invention concerne le domaine des procédés de caractérisation de transistors, et porte en particulier sur un procédé de caractérisation en mode impulsionnel d'un transistor à semi-conducteur III-V permettant de prendre en compte la variation dynamique de l'état de charge des pièges dans le transistor, et sur un banc de mesures associé.

De nos jours, les transistors à semi-conducteur III-V, tels que les transistors en technologie GaN, sont utilisés dans de nombreux domaines d'applications (par exemple, télécommunications, militaires et industriels). Cette technologie offre une forte densité de puissance, et permet d'atteindre des fréquences de fonctionnement élevées, deux caractéristiques essentielles, notamment pour des applications d'amplification radiofréquence (RF).

En contrepartie, le phénomène de pièges est présent et impacte significativement les performances réelles atteignables avec cette technologie. Ces pièges résultent d'impuretés ou de défauts dans le réseau cristallin ou à sa surface. L'étude de ces pièges est indispensable afin de mieux en comprendre les mécanismes et d'en limiter les effets sur les performances du composant mais aussi afin de les modéliser pour en tenir compte lors de la phase de conception.

La technique de mesure en mode impulsionnel permet de caractériser les effets transitoires induits par les pièges dans le transistor tout en diminuant l'impact des effets thermiques. Cette méthode de mesure consiste à appliquer des signaux impulsionnels sur les accès du composant (généralement la grille et le drain) et d'en mesurer les réponses, à savoir les tensions et courants résultants. Dans sa version standard, cette technique de mesures en mode impulsionnel est à deux niveaux (on parle aussi de système à simple impulsion). Le signal est constitué d'un niveau fixe (niveau de polarisation) et d'un niveau variable (le niveau de l'impulsion). Ainsi, il est possible de mesurer les caractéristiques I-V (courant-tension) d'un composant en balayant le niveau variable (impulsionnel) autour d'un point fixe (le niveau de polarisation) et ainsi de modifier l'état de charge des pièges dans le composant. Généralement, dans la technique standard, une première impulsion continue dont le niveau de tension est constant sur toute la durée de la première impulsion est appliquée sur la grille du transistor, et simultanément une seconde impulsion continue dont le niveau de tension est constant sur toute la durée de la seconde impulsion est appliquée sur le drain du transistor. Dans le cas d'un composant ayant une sensibilité à la commande de drain et en raison de l'asymétrie des constantes de temps de capture et d'émission des pièges dans le transistor, un système à simple impulsion aura pour conséquence de fixer le niveau moyen des pièges pour Vds < Vds0 et rendra variable le niveau moyen pour Vds > Vds0 (où Vds est la tension drain-source impulsionnelle du transistor, et Vds0 est la tension drain-source au point de polarisation).

La compréhension des phénomènes de pièges par la mesure en mode impulsionnel a permis d'améliorer cette technique. Un raisonnement similaire pour être fait sur la grille, mais il faut dans ce cas considérer la valeur absolue de Vgs (|Vgs|). Une manière de tenir compte de l'état de charge réel des pièges, à savoir celui imposé par l'environnement du composant dans son application finale, consiste à appliquer une pré-impulsion continue (c'est-à-dire, ayant un niveau de tension constant sur toute la durée de la pré-impulsion) afin de conditionner l'état de charge des pièges à un niveau adéquat en fonction de l'application finale. Ainsi, cette technique est dite à trois niveaux (ou système à double impulsion), à savoir les deux niveaux de la technique standard et un niveau supplémentaire qui est celui de la pré-impulsion. Cette technique améliorée permet ainsi de fixer l'état de charge des pièges dans les conditions d'utilisation représentatives de la droite de charge optimale.

La modélisation des phénomènes de pièges dans les technologies de semi-conducteur III-V est un enjeu majeur pour la conception de circuit micro-ondes. En effet, ces pièges entraînent la dégradation des performances attendues du composant (diminution de la puissance de sortie et du rendement en puissance ajoutée, par exemple). Une façon de mettre les effets de pièges en évidence est d'effectuer des mesures I-V en mode impulsionnel à différents points de polarisation. On constate alors que les réseaux I-V mesurés diffèrent en fonction du point de polarisation du transistor. Pour des points de polarisation éloignés du point de polarisation Vgs0 = 0V et Vds0 = 0V, une diminution de la valeur de saturation du courant et également une augmentation de la tension de coude sont constatées, entraînant de fait une diminution des performances en régime fort signal.

Le système à double impulsion (ou à trois niveaux) a l'avantage de fixer l'état de charge des pièges sur l'ensemble du réseau I-V et ainsi de minimiser l'asymétrie des constantes de temps de charge et d'émission des pièges. Contrairement à un système à simple impulsion (ou à deux niveaux), dans le système à double impulsion, les réseaux I-V sont quasiment identiques quel que soit le point de polarisation, cela est dû au fait que l'état de charge des pièges est fixé par la pré-impulsion et non par le point de polarisation lui-même. Cependant, dans les systèmes à double impulsion existants, le niveau de la pré-impulsion est fixé à un niveau constant imposant un état de charge des pièges constant quelle que soit la zone de la caractéristique I-V explorée, ce qui ne permet pas de prendre en compte les effets dynamiques des pièges dans le transistor.

En outre, il est également à noter que l'amplitude d'un signal RF appliqué sur la grille du transistor a également un impact sur l'état de charge des pièges du transistor. Il a en effet été montré que l'état de charge des pièges dans le transistor est modifié en fonction du niveau de puissance appliqué au signal RF. En effet, pour des applications micro-ondes, les signaux réels d'excitation des transistors ont une caractéristique élevée de rapport entre puissance crête et puissance moyenne (PAPR). Cela signifie que l'enveloppe du signal RF varie au cours du temps entraînant une variation importante de la puissance instantanée. Les effets de pièges sont des phénomènes transitoires qui évoluent donc dans le temps en fonction des niveaux des tensions appliquées au transistor. Ainsi, l'état de charge des pièges est impacté de manière dynamique par la variation instantanée des signaux et donc l'enveloppe du signal RF.

Ainsi, comme il a été présenté ci-dessus, la polarisation ainsi que l'amplitude de l'enveloppe du signal RF modifient l'état de charge des pièges entraînant la dégradation des performances du transistor de manière dynamique.

La prise en compte de ces effets dynamiques est ainsi primordiale et nécessite la caractérisation et la modélisation de ces phénomènes de manière plus précise. Cependant, les techniques connues de mesure I-V en mode impulsionnel (à savoir à simple impulsion ou à double impulsion), servant à la modélisation de la source de courant de sortie du transistor, ne permettent pas de tenir compte des états de charges dynamiques des pièges dans les conditions d'utilisation de l'application finale et ne permettent donc pas de représenter le comportement réel du transistor dans son environnement final.

Le document Pulsed I-V and RF characterization and modeling of AIGaN HEMTs and Graphene FETs. (Caractérisation I-V et RF pulsée et modélisation des HEMTs AIGaN et des FETs en graphène), Poornakarthik Nakkala. Electronics. Université de Limoges, 2015, p1-191 décrit des techniques de mesures d'impulsions de l'état de la technique.Les deux documents suivants décrivent également des méthodes de caractérisation selon l'état de la technique :

- Double-pulse characterization of GaN-on-Sapphire FETs for technology development (Caractérisation à double impulsion de transistors à effet de champ en GaN sur saphir pour le développement technologique), G. P. Gibiino et al., 2016 21st International Conference on Microwave, Radar and Wireless Communications (MIKON), Krakow, Poland, 2016, pp. 1-4 ;
- Isotrap Pulsed IV Characterization of GaN HEMTs for PA Design (Caractérisation Isotrap Pulsed IV des HEMTs GaN pour la conception d'amplificateurs de puissance), G. P. Gibiino, C. Florian, A. Santarelli, T. Cappello and Z. Popovié, in IEEE Microwave and Wireless Components Letters, vol. 28, no. 8, pp. 672-674, Aug. 2018.

La présente invention vise à résoudre les inconvénients de l'état antérieur de la technique, en proposant un procédé de caractérisation en mode impulsionnel d'un transistor à semi-conducteur III-V, dans lequel une pré-impulsion RF variable est appliquée préalablement sur la grille du transistor, puis une première impulsion à courant continu (DC pour « Direct Current », ou CC pour « Courant continu ») est appliquée sur la grille du transistor et une seconde impulsion DC est appliquée sur le drain du transistor, le niveau de puissance de la pré-impulsion RF étant défini selon une première loi de variation prédéterminée de manière à modifier de manière dynamique l'état de charge des pièges dans le transistor. Le procédé selon la présente invention permet ainsi la mesure du réseau I-V du transistor en tenant compte de la variation dynamique de l'état de charge des pièges, ce qui permet une modélisation plus précise de la source de courant de sortie du transistor dans des conditions proches de celles de l'application finale.

La présente invention a donc pour objet un procédé de caractérisation en mode impulsionnel d'un transistor à semi-conducteur III-V, le transistor comprenant une grille, un drain et une source, caractérisé par le fait que ledit procédé comprend les étapes suivantes :

a) définir un point de polarisation du transistor correspondant à une tension grille-source de polarisation Vgs0 et à une tension drain-source de polarisation Vds0 ;
b) définir une impédance de charge appliquée au drain du transistor ;
c) définir une période T, et pour chaque période T :c1) appliquer une pré-impulsion radiofréquence, RF, sur la grille du transistor de manière à fixer l'état de charge des pièges dans le transistor, ladite pré-impulsion RF ayant une fréquence f0 prédéfinie, une durée de pré-impulsion TRF prédéfinie et un niveau de puissance NRF défini selon une première loi de variation prédéterminée ;
c2) après la pré-impulsion RF, appliquer une première impulsion à courant continu (DC) sur la grille du transistor et une seconde impulsion DC sur le drain du transistor, la première impulsion DC ayant une première durée T1 et la seconde impulsion DC ayant une seconde durée T2, les première et seconde durées T1, T2 étant au moins partiellement simultanées, la première impulsion DC et la seconde impulsion DC ayant, respectivement, un premier niveau DC N1 et un second niveau DC N2 définis selon une seconde loi de variation prédéterminée ; et
c3) pendant une durée de mesure TM pendant l'application simultanée des première et seconde impulsions DC, mesurer le courant Id circulant dans le drain du transistor ;
dans lequel, pour chaque période T, dans la première loi de variation, le niveau de puissance NRF de la pré-impulsion RF dépend des premier N1 et second N2 niveaux DC des première et seconde impulsions DC appliquées ultérieurement dans la même période T ;
dans lequel, pour chaque période T, dans la seconde loi de variation, le premier niveau DC N1 est égal à Vgs0 plus une première valeur V1 définie par la seconde loi de variation en fonction de la période T actuelle, et le second niveau DC N2 est égal à Vds0 plus une seconde valeur V2 définie par la seconde loi de variation en fonction de la période T actuelle, les première V1 et seconde V2 valeurs étant des nombres réels.

Par transistor à semi-conducteur III-V, on entend un transistor comportant un matériau semi-conducteur composé d'un ou plusieurs éléments de la colonne III (bore, gallium, aluminium, indium, etc.) et de la colonne V (arsenic, antimoine, phosphore, etc.) du tableau périodique de Mendeleïev. A titre d'exemple, les transistors au nitrure de gallium (GaN) sont des transistors à semi-conducteur III-V.

En outre, par caractérisation en mode impulsionnel du transistor, on entend la mesure des courants et tensions sur la grille et le drain du transistor lors de l'application de signaux impulsionnels sur la grille et le drain du transistor, de manière à obtenir à titre d'exemple plusieurs courbes du courant de drain en fonction de la tension de drain, chacune desdites courbes correspondant à une tension de grille particulière, l'ensemble desdites courbes constituant ainsi un réseau I-V (ou réseau I(V) ou réseau courant-tension) permettant de caractériser le comportement du transistor sous test, notamment pour mettre en évidence les effets de pièges dans le transistor.

Dans la présente invention, la pré-impulsion RF, dont le niveau de puissance est défini selon une première loi de variation prédéterminée en fonction des niveaux DC des première et seconde impulsions DC appliquées ultérieurement dans la même période T (c'est-à-dire, en fonction de la zone I-V explorée), permet ainsi de modifier de manière dynamique l'état de charge des pièges dans le transistor, ce qui permet de connaître l'excursion réelle de la source de courant de sortie extrinsèque du transistor.

Par conséquent, la présente invention permet une meilleure expertise de l'impact des pièges sur les performances finales de l'application. Aussi, ces mesures peuvent être utilisées pour modéliser la source de courant de sortie du composant, à condition que le modèle ne soit utilisé qu'au point de polarisation de repos fixé lors de la mesure. Dans le cas où le modèle doit être valable pour différents points de polarisation, le procédé de caractérisation de la présente invention doit être répété et les résultats utilisés pour déterminer le modèle de pièges précisément. Le mode impulsionnel du procédé permet une limitation des effets d'auto-échauffement et donc une meilleure séparation des effets thermiques et des effets de pièges sur les performances électriques du composant.

V1 et V2 peuvent être des nombres réels positifs, négatifs ou nuls en fonction de la période T. La seconde loi de variation permet, sur l'ensemble des périodes T du procédé de caractérisation, un séquençage de (N1, N2) autour du point de polarisation de manière à construire le réseau I-V du transistor sous test.

Plusieurs périodes T successives sont nécessaires pour réaliser le procédé de caractérisation selon la présente invention. A chaque période T, une pré-impulsion RF puis deux impulsions DC sont appliquées au transistor sous test, les niveaux NRF, N1 et N2 des trois impulsions étant définis par les première et seconde lois de variation prédéfinies. Le procédé de caractérisation prend fin (c'est-à-dire, fin de la mesure et de la succession des périodes T) lorsque l'ensemble du réseau I-V a été exploré autour du point de polarisation.

Selon une caractéristique particulière de l'invention, le procédé de caractérisation comprend en outre, entre les étapes a) et b), une étape de détermination de la période T et des durées TRF, T1 et T2 en fonction de la mesure des constantes de temps des pièges dans le transistor sur la grille et sur le drain du transistor.

Ainsi, la mesure des constantes de temps des pièges sur la grille (« gate-lag ») et le drain (« drain-lag ») du transistor permet de définir les différentes temporisations de manière à éviter tout effet cumulatif des effets de pièges lors des mesures.

Selon une caractéristique particulière de l'invention, le procédé de caractérisation comprend en outre, entre les étapes a) et b) :

d1) définir les bornes inférieure et supérieure [Vgsmin ;
Vgsmax] du premier niveau DC N1 dans la seconde loi de variation, où :

Vgsmax est déterminée en mesurant le courant de grille Ig du transistor en fonction de la tension DC Vgs appliquée à la grille du transistor pour une tension Vds nulle appliquée au drain du transistor, puis en définissant Vgsmax comme étant la valeur de Vgs pour laquelle le courant de grille Ig atteint une valeur de seuil de courant prédéterminée ; et
Vgsmin $\leq$ Vp où Vp est la tension de pincement du transistor ; et
d2) définir les bornes inférieure et supérieure [Vdsmin ; Vdsmax] du second niveau DC N2 dans la seconde loi de variation, où Vdsmin = 0V et Vdsmax = 2 * Vds0.

Il est à noter que la valeur de seuil de courant prédéterminée dépend du type de transistor.

Avantageusement, la définition des bornes de N1 et N2 est effectuée après la détermination de T, TRF, T1 et T2.

Selon une caractéristique particulière de l'invention, le procédé de caractérisation comprend en outre, entre les étapes b) et c), une étape de détermination de la première loi de variation comprenant :

e1) pour l'impédance de charge définie appliquée sur le drain du transistor, mesurer l'amplitude de Vgs au cours du temps à f0 ou à une harmonique de f0 en fonction de la puissance Pavs émise dans une impulsion RF à f0 ou à une harmonique de f0, puis définir différents niveaux de puissance Pavs1, ..., Pavsn de l'impulsion RF par découpe de la courbe de variation de l'amplitude mesurée de Vgs en fonction de la puissance Pavs, chaque niveau de puissance Pavs1, ..., Pavsn correspondant à une certaine plage de la tension Vgs ;

e2) pour l'impédance de charge définie, mesurer la courbe de variation de la tension Vgs en fonction de la tension Vds de manière à déterminer des couples possibles de valeurs (N1, N2) ; et

e3) pour chaque couple possible de valeurs (N1, N2), déterminer le niveau de puissance NRF correspondant à appliquer à la pré-impulsion RF parmi les différents niveaux de puissance Pavs1, ..., Pavsn.

Ainsi, à chaque période T, le niveau de puissance NRF de la pré-impulsion RF est l'un parmi les différents niveaux de puissance Pavs1, ..., Pavsn, et est choisi en fonction des niveaux DC N1 et N2 qui seront appliqués aux deux impulsions DC dans la même période T. La première loi de variation prend ainsi en compte la zone explorée du réseau I-V du transistor pour fixer le niveau de puissance NRF de la pré-impulsion RF dans la période T en question. Pour chaque zone, et donc pour chaque niveau de puissance Pavs, les excursions en tension V1 et V2 par rapport au point de polarisation changent.

A titre d'exemple, les différents niveaux de puissance Pavs1, ..., Pavsn peuvent être définis en découpant la courbe de variation de Vgs à pas de Vgs constant.

Selon un premier mode de réalisation, l'étape de définition de l'impédance de charge b) comprend : mesurer, au point de polarisation, le conjugué du coefficient de réflexion de sortie S22 du transistor (2) à la fréquence f0 et déterminer une impédance de charge initiale correspondante ; effectuer une mesure cumulant un balayage en puissance avec une variation de l'impédance de charge autour de ladite impédance de charge initiale afin de déterminer l'impédance de charge optimale pour laquelle l'excursion de la tension Vds est maximale pour un niveau de compression minimal ; et définir l'impédance de charge comme étant égale à l'impédance de charge optimale déterminée.

Ainsi, dans ce premier mode de réalisation, l'application finale n'est pas connue (ou n'impose aucune condition sur l'impédance de charge et le niveau de compression), et l'étape b) permet de trouver les conditions de charge optimales (c'est-à-dire, l'impédance de charge optimale) du composant sous test afin de maximiser l'aire de mesure nécessaire pour couvrir le réseau I-V.

L'impédance de charge optimale est choisie de manière à rendre maximales les excursions des tensions d'entrée et de sortie du transistor tout en minimisant le niveau de compression du transistor.

Selon un second mode de réalisation, dans l'étape b), l'impédance de charge est définie par l'utilisateur en fonction de l'application finale, ce qui définit une contrainte sur le niveau de compression du transistor. Ainsi, dans ce second mode de réalisation, l'impédance de charge et le niveau de compression sont imposés par l'application finale du transistor.

Selon une caractéristique particulière de l'invention, le procédé de caractérisation comprend en outre, entre les étapes b) et c), une étape de détermination de la seconde loi de variation comprenant :

f1) pour au moins la première période T, définir V1 = 0 et V2 = 0 ; et

f2) pour chacune des périodes T suivantes, définir V1 et V2 de telle sorte que, sur l'ensemble des périodes T, N1 et N2 varient autour du point de polarisation tout en s'éloignant progressivement de ce dernier (de préférence, selon une spirale représentant le cycle de charge du composant soumis à une rampe de puissance).

Au point de polarisation (Vgs0, Vds0), le niveau de puissance RF est nulle puis, au fur et à mesure de la séquence de mesure, les niveaux des impulsions DC augmentent et décrivent une spirale autour du point de polarisation, à la manière du cycle de charge réel du composant dans son environnement final (l'application finale). Aussi, le niveau de puissance NRF de la pré-impulsion RF augmente de manière incrémentale (Pavs1, Pavs2, ..., Pavs11) au fur et à mesure de la séquence de mesure.

Selon une caractéristique particulière de l'invention, le procédé de caractérisation comprend en outre, à chaque période T, la mesure des paramètres S sur la grille et le drain du transistor pendant l'application des première et seconde impulsions DC.

Ainsi, les paramètres S (ou paramètres petits signaux ou paramètres de diffraction) du transistor peuvent être déterminés par mesure, à l'aide d'un analyseur de réseau vectoriel, des ondes incidentes et réfléchies sur la grille et le drain du transistor.

Selon une caractéristique particulière de l'invention, l'étape c3) comprend en outre : pendant la durée de mesure TM, mesurer la tension de grille, la tension de drain et le courant de grille du transistor.

Ainsi, la mesure des tensions de grille et de drain permet, par exemple, de vérifier si ces deux tensions sont ou non arrivées au niveau des consignes N1 et N2 et de réaliser un asservissement jusqu'à l'atteinte des consignes (c'est-à-dire, le même couple (N1, N2) est appliqué pendant plusieurs périodes T jusqu'à ce que cette consigne soit atteinte, puis le courant de drain peut être mesuré sur un nombre prédéfini de périodes T puis moyenné).

La présente invention a également pour objet un banc de mesures pour la caractérisation en mode impulsionnel d'un transistor à semi-conducteur III-V, le banc de mesure comprenant un générateur RF impulsionnel, une première source de tension DC impulsionnelle associée à un premier multimètre configuré pour mesurer des tensions et courants, une seconde source de tension DC impulsionnelle associée à un second multimètre configuré pour mesurer des tensions et courants, un premier té de polarisation et un second té de polarisation, le générateur RF impulsionnel et la première source de tension DC impulsionnelle étant configurées pour être reliées à la grille du transistor par l'intermédiaire du premier té de polarisation, la seconde source de tension DC impulsionnelle et une impédance de charge étant configurées pour être reliées au drain du transistor par l'intermédiaire du second té de polarisation, le banc de mesures comprenant en outre un dispositif de commande configuré pour commander le générateur RF impulsionnel, la première source de tension DC impulsionnelle et la seconde source de tension DC impulsionnelle de manière à réaliser le procédé de caractérisation tel que décrit ci-dessus.

Le générateur RF impulsionnel est un générateur RF de signaux sinusoïdaux en mode pulsé.

Selon une caractéristique particulière de l'invention, le banc de mesure comprend en outre un analyseur de réseau vectoriel configuré pour être relié à la grille et au drain du transistor par l'intermédiaire de coupleurs.

Ainsi, l'analyseur de réseau vectoriel permet de mesurer les ondes incidentes et réfléchies sur la grille et le drain du transistor sous test, de manière à déterminer les paramètres S correspondants.

Selon une caractéristique particulière de l'invention, le banc de mesures comprend en outre au moins deux wattmètres configurés pour être reliés à la grille et au drain du transistor par l'intermédiaire de coupleurs.

Pour mieux illustrer l'objet de la présente invention, on va en décrire ci-après, à titre illustratif et non limitatif, deux modes de réalisation préférés, avec référence aux dessins annexés.

Sur ces dessins :

[Fig. 1] est un schéma de principe d'un banc de mesures selon la présente invention ;
[Fig. 2] est un chronogramme à titre d'exemple représentant la pré-impulsion RF et les deux impulsions DC du procédé de caractérisation selon la présente invention ;
[Fig. 3] montre différents chronogrammes à titre d'exemple représentant les différentes tensions du schéma de principe de la Figure 1 ;
[Fig. 4] est un schéma fonctionnel d'un banc de mesures selon la présente invention ;
[Fig. 5] est un organigramme représentant un procédé de caractérisation en mode impulsionnel selon un premier mode de réalisation de la présente invention ;
[Fig. 6] illustre une mesure de type « gate-lag » à titre d'exemple ;
[Fig. 7] montre différentes courbes à titre d'exemple du niveau de compression du transistor sous test en fonction de l'excursion en tension de drain du transistor sous test, pour différentes valeurs d'impédance de charge ;
[Fig. 8] représente une courbe à titre d'exemple de l'excursion en tension de grille du transistor sous test en fonction de la puissance d'une impulsion RF appliquée sur la grille du transistor sous test, ainsi qu'une courbe à titre d'exemple de l'excursion en tension de grille du transistor sous test en fonction de l'excursion en tension de drain du transistor sous test ;
[Fig. 9] est un diagramme à titre d'exemple représentant les différents couples (N1, N2) utilisés lors du procédé de caractérisation de la présente invention ;
[Fig. 10] représente un réseau I-V à titre d'exemple mesuré à l'aide du procédé de caractérisation selon la présente invention ;
[Fig. 11] est un schéma à titre d'exemple représentant trois zones de mesure du réseau I-V correspondant à trois niveaux de puissance RF différents dans le cas du premier mode de réalisation de la présente invention ;
[Fig. 12] représente trois réseaux I-V différents mesurés respectivement à l'aide d'une technique existante à simple impulsion, d'une technique existante à double impulsion et du procédé de caractérisation selon la présente invention ;
[Fig. 13] est un organigramme représentant un procédé de caractérisation en mode impulsionnel selon un second mode de réalisation de la présente invention ; et
[Fig. 14] est un schéma à titre d'exemple représentant trois zones de mesure du réseau I-V correspondant à trois niveaux de puissance RF différents dans le cas du second mode de réalisation de la présente invention.

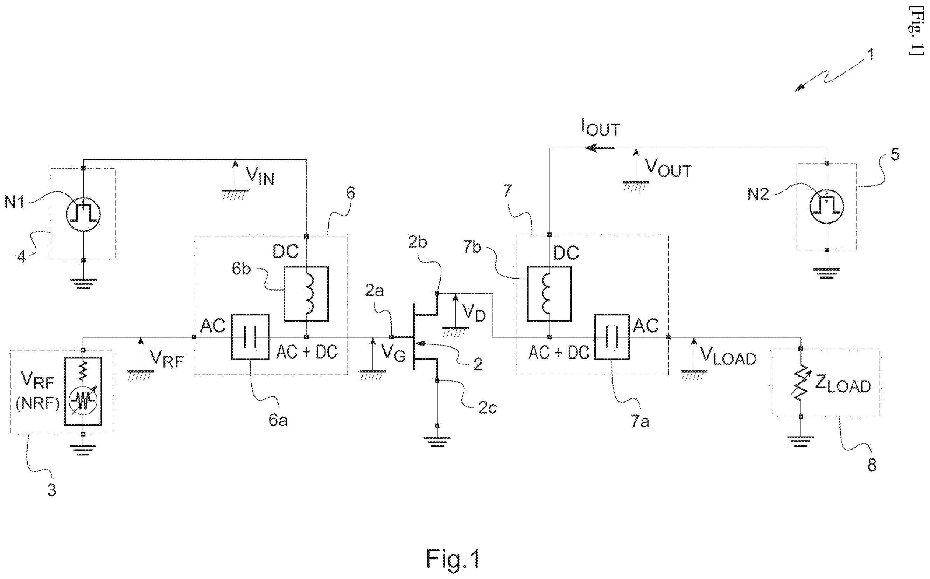

Si l'on se réfère à la Figure 1, on peut voir qu'il y est représenté le schéma de principe d'un banc de mesures 1 selon la présente invention pour la caractérisation en mode impulsionnel d'un transistor 2 qui est un transistor à semi-conducteur III-V tel qu'un transistor de type GaN.

Le transistor 2 comprend une grille 2a, un drain 2b et une source 2c reliée à la masse.

Le banc de mesures 1 comprend un générateur radiofréquence (RF) impulsionnel 3, une première source de tension DC impulsionnelle 4, une seconde source de tension DC impulsionnelle 5, un premier té de polarisation 6 et un second té de polarisation 7.

Le générateur RF impulsionnel 3 et la première source de tension DC impulsionnelle 4 sont reliées à la grille 2a du transistor 2 par l'intermédiaire du premier té de polarisation 6.

Le premier té de polarisation 6 comprend un condensateur 6a relié entre le générateur RF impulsionnel 3 et la grille 2a du transistor 2, et une bobine d'inductance 6b reliée entre la première source de tension DC impulsionnelle 4 et la grille 2a du transistor 2. Ainsi, le premier té de polarisation 6 permet uniquement le passage des signaux alternatifs (AC pour « Alternative Current ») entre le générateur RF impulsionnel 3 et la grille 2a du transistor 2, et uniquement le passage de la tension DC entre la première source de tension DC impulsionnelle 4 et la grille 2a du transistor 2.

La seconde source de tension DC impulsionnelle 5 et une impédance de charge 8 sont reliées au drain 2b du transistor 2 par l'intermédiaire du second té de polarisation 7.

Le second té de polarisation 7 comprend un condensateur 7a relié entre le drain 2b du transistor 2 et l'impédance de charge 8, et une bobine d'inductance 7b reliée entre la seconde source de tension DC impulsionnelle 5 et le drain 2b du transistor 2. Ainsi, le second té de polarisation 7 permet uniquement le passage des signaux alternatifs entre le drain 2b du transistor 2 et l'impédance de charge 8, et uniquement le passage de la tension DC entre la seconde source de tension DC impulsionnelle 5 et le drain 2b du transistor 2.

Préférablement, la valeur $Z_{LOAD}$ de l'impédance de charge 8 est modifiable à l'aide d'un dispositif d'accord (ou « tuner ») de charge.

Sur la Figure 1, $V_{RF}$ correspond à la tension à la sortie du générateur RF impulsionnel 3, $V_{IN}$ correspond à la tension à la sortie de la première source de tension DC impulsionnelle 4, $V_{OUT}$ correspond à la tension de sortie de la seconde source de tension DC impulsionnelle 5, $V_G$ correspond à la tension de grille du transistor 2, $V_D$ correspond à la tension de drain du transistor 2, $V_{LOAD}$ correspond à la tension aux bornes de l'impédance de charge 8, et $I_{OUT}$ correspond au courant de drain (ou courant de sortie) du transistor 2.

Le générateur RF impulsionnel 3 est configuré pour générer des pré-impulsions de signal RF avec un niveau de puissance NRF modifiable à chaque pré-impulsion.

La première source de tension DC impulsionnelle 4 est configurée pour générer des impulsions de signal DC avec un niveau haut N1 qui est modifiable à chaque impulsion.

La seconde source de tension DC impulsionnelle 5 est configurée pour générer des impulsions de signal DC avec un niveau haut N2 qui est modifiable à chaque impulsion.

Le schéma de principe du banc de mesures 1 comprend en outre un dispositif de commande (non représenté sur la Figure 1) configuré pour commander le générateur RF impulsionnel 3, la première source de tension DC impulsionnelle 4 et la seconde source de tension DC impulsionnelle 5 de manière à temporiser les différentes impulsions afin de réaliser un procédé de caractérisation sur le transistor 2 qui sera décrit plus en détail par la suite.

Préalablement à l'application des différentes impulsions, un point de polarisation du transistor 2 doit être défini par l'utilisateur, ledit point de polarisation correspondant à une tension grille-source de polarisation Vgs0 et à une tension drain-source de polarisation Vds0. En outre, la valeur $Z_{LOAD}$ de l'impédance de charge 8 doit également être définie.

A titre d'exemple, le transistor 2 peut être un transistor à haute mobilité d'électrons (HEMT) en technologie au nitrure d'aluminium-gallium (AlGaN) ou au nitrure de gallium (GaN) (par exemple, de 0,4 mm de périphérie), destiné à des applications d'amplification en bande X avec une fréquence d'intérêt $f_0$ = 10 GHz, et le point de polarisation peut être fixé pour un fonctionnement en classe AB soit Vgs0 = -3,2V et Vds0 = 20V (soit environ 100mA/mm).

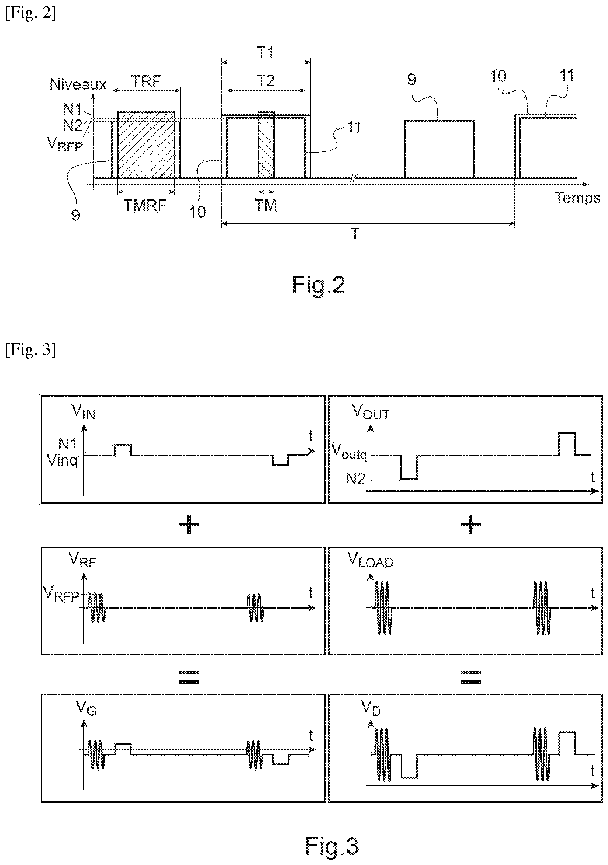

Si l'on se réfère à la Figure 2, on peut voir qu'il y est représenté une temporisation à titre d'exemple de la pré-impulsion RF et des deux impulsions DC provenant respectivement du générateur RF impulsionnel 3 et des première et première sources de tension DC impulsionnelles 4 et 5.

Une période T est définie et, pour chaque période T, une pré-impulsion RF 9 est appliquée sur la grille 2a du transistor 2 de manière à fixer l'état de charge des pièges dans le transistor 2, ladite pré-impulsion RF 9 ayant une fréquence f0 prédéfinie, une durée de pré-impulsion TRF prédéfinie et un niveau de puissance NRF défini selon une première loi de variation prédéterminée qui sera décrite par la suite. Afin de ne pas surcharger la Figure 2, la pré-impulsion RF 9 a uniquement été représentée sous la forme d'un créneau. En réalité, le signal temporel résultant noté $V_{RF}(t)$ est décrit par les équations suivantes :

$$V_{RF}(t) = \begin{cases} V_{RFP} . \cos(2\pi f_0 t + \varphi) , t \in [TRF] \\ 0 , t \notin [TRF] \end{cases}$$

où $f_0$ est la fréquence du signal RF, $\varphi$ est la phase du signal RF, et $V_{RFP}$ est l'amplitude du signal RF qui est proportionnelle au niveau de puissance NRF délivré par le générateur RF impulsionnel 3.

Par la suite, après la pré-impulsion RF 9, une première impulsion DC 10 est appliquée sur la grille 2a du transistor 2 et une seconde impulsion DC 11 est appliquée sur le drain 2b du transistor 2.

La première impulsion DC 10 possède une première durée T1 et la seconde impulsion DC 11 possède une seconde durée T2, les première et seconde durées T1 et T2 étant partiellement simultanées. Il est à noter que, bien que sur la Figure 2 la première durée T1 soit supérieure à la seconde durée T2 et enveloppe totalement cette dernière, on pourrait également avoir T1 = T2 ou T2 > T1, sans s'écarter du cadre de la présente invention.

Le niveau haut N1 de la première impulsion DC 10 et le niveau haut N2 de la seconde impulsion DC 11 sont définis selon une seconde loi de variation prédéterminée qui sera décrite par la suite.

Ainsi, pour chaque période T, les première et seconde lois de variation définissent des valeurs particulières pour NRF, N1 et N2.

Chacune des première et seconde impulsions DC 10, 11 possède un niveau haut (respectivement, N1 et N2) et un niveau bas (correspondant à l'axe des abscisses sur la Figure 2).

Les signaux impulsionnels RF et DC 9, 10, 11 sont synchronisés et ont la période commune T.

Outre l'évolution temporelle des signaux générés par les sources impulsionnelles RF 3 et DC 4, 5, le chronogramme de la Figure 2 représente également les instants de mesure des signaux résultants du transistor 2.

Ainsi, pendant l'application simultanée des première et seconde impulsions DC 10, 11, les signaux résultants DC (à savoir, le courant de drain $I_{OUT}$, et facultativement les tensions de drain $V_D$ et de grille $V_G$ et le courant de grille) sont mesurés pendant une durée de mesure notée TM. En outre, les ondes incidentes et réfléchies sur la grille 2a et le drain 2b du transistor 2 peuvent également être mesurées, à l'aide d'un analyseur de réseau vectoriel, pendant l'application de la pré-impulsion RF 9 sur une durée de mesure notée TMRF.

Les caractéristiques temporelles des signaux d'excitation 9, 10, 11 sont fixées pour s'assurer qu'entre deux points de mesure, le courant de sortie $I_{OUT}$ est revenu à son état établi, permettant ainsi d'éviter tout effet cumulatif qui pourrait entacher les résultats de mesure obtenus. Pour cela, une étude préliminaire est réalisée afin de déterminer les constantes de temps des pièges à partir de deux mesures temporelles où on fait varier les tensions de grille $V_G$ et de drain $V_D$ respectivement. A titre d'exemple, les caractéristiques temporelles peuvent être les suivantes : T1 = 1μs, T2 = 1μs, TRF = 1μs, T = 0,3s, TM = 0,2μs et TMRF = 0,7μs.

Plusieurs périodes T successives sont nécessaires pour réaliser le procédé de caractérisation selon la présente invention. A chaque période T, une pré-impulsion RF 9 puis deux impulsions DC 10 et 11 sont appliquées au transistor 2 sous test, les niveaux NRF, N1 et N2 des trois impulsions étant définis par les première et seconde lois de variation prédéfinies. Le procédé de caractérisation prend fin (c'est-à-dire, fin de la mesure et de la succession des périodes T) lorsque l'ensemble du réseau I-V a été exploré autour du point de polarisation Vgs0, Vds0 défini.

Si l'on se réfère à la Figure 3, on peut voir qu'il y est représenté différents chronogrammes à titre d'exemple représentant les différentes tensions $V_{IN}$, $V_{OUT}$, $V_{RF}$, $V_{LOAD}$, $V_G$ et $V_D$ du banc de mesures 1 lors de deux périodes T successives.

Le signal DC impulsionnel $V_{IN}$ comprend N1 comme niveau haut variable (qui est fonction de la période T actuelle) et Vinq comme niveau bas fixe, et le signal DC impulsionnel $V_{OUT}$ comprend N2 comme niveau haut variable (qui est fonction de la période T actuelle) et Voutq comme niveau bas fixe.

On peut voir que les signaux DC impulsionnels $V_{IN}$ et $V_{OUT}$ et la pré-impulsion RF en entrée $V_{RF}$ se recombinent au niveau des accès $V_G$ et $V_D$ du transistor 2.

Le signal RF en sortie du transistor 2 est fonction du signal RF d'entrée, du gain en tension du transistor 2 et la valeur $Z_{LOAD}$ de l'impédance de charge.

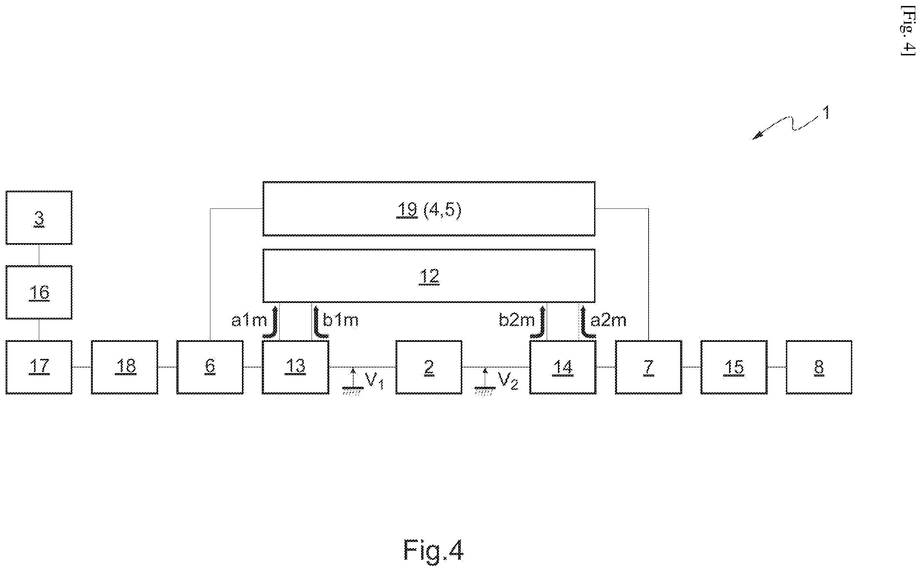

Si l'on se réfère à la Figure 4, on peut voir qu'il y est représenté un autre schéma de principe du banc de mesures 1 qui permet d'effectuer des mesures en petits signaux et en grands signaux en mode impulsionnel tout en contrôlant les conditions de charge du transistor 2 sous test à caractériser.

Comparé à la Figure 1, le banc de mesures 1 de la Figure 4 comprend en outre un analyseur de réseau vectoriel 12 relié à la grille 2a et au drain 2b du transistor 2 par l'intermédiaire de deux coupleurs 13 et 14.

Les coupleurs 13 et 14 permettent de prélever une fraction des ondes incidentes et réfléchies en entrée et en sortie du transistor 2 sous test afin de les transmettre à l'analyseur de réseau vectoriel 12.

L'analyseur de réseau vectoriel 12 permet de mesurer les ondes incidentes et réfléchies (a1m, b1m) et (a2m, b2m), de manière à déterminer les paramètres S correspondants du transistor 2.

A la Figure 4, V1 représente l'excursion en tension de grille (en tension d'entrée) par rapport à Vgs0 (point de polarisation), et V2 représente l'excursion en tension de drain (ou en tension de sortie) par rapport à Vds0 (point de polarisation).

Les premier et second tés de polarisation 6 et 7 permettent de transmettre les signaux impulsionnels DC et RF au transistor 2 sous test.

Les première et seconde sources de tension DC impulsionnelles 4 et 5 sont intégrées dans un système impulsionnel I-V (courant-tension) 19 relié aux coupleurs 13 et 14 par l'intermédiaire des tés de polarisation 6 et 7, ledit système impulsionnel I-V permettant à la fois de générer les impulsions DC 10 et 11 et de mesurer les signaux résultants DC tels que les courants de drain et de grille et les tensions de drain et de grille.

Un dispositif d'accord d'impédance de charge de sortie 15 est relié entre le second té de polarisation 7 et la charge de sortie 8 et permet de commander la valeur de l'impédance de charge de sortie 8 présentée au transistor 2 sous test, la charge de sortie 8 (par exemple, 50 Ohms) étant dimensionnée afin de supporter la puissance générée par le transistor 2 sous test.

Le générateur RF impulsionnel 3 est d'amplitude variable à la fréquence de fonctionnement f0, et est reliée au premier té de polarisation 6 par l'intermédiaire successivement d'un amplificateur d'instrumentation 16 qui permet d'augmenter le niveau du signal RF, d'un circulateur 17 qui permet d'éviter que l'énergie réfléchie (en cas de désadaptation du transistor 2) ne soit renvoyée vers l'amplificateur d'instrumentation 16 et le générateur RF 3 et ne les endommage, et d'un dispositif d'accord d'impédance d'entrée 18 qui permet de commander l'impédance d'entrée présentée au transistor 2 sous test.

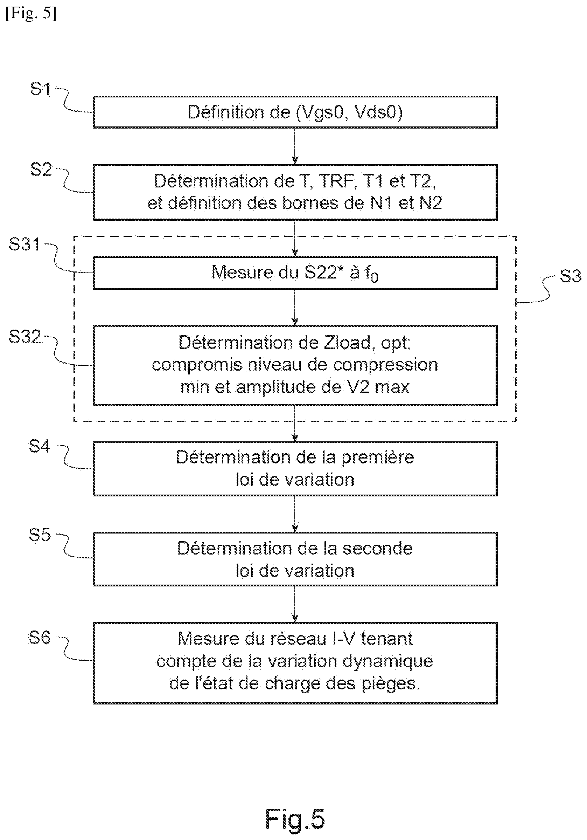

Si l'on se réfère à la Figure 5, on peut voir qu'il y est représenté l'organigramme d'un procédé de caractérisation selon un premier mode de réalisation de la présente invention, à savoir dans le cas où l'application finale du transistor 2 sous test n'est pas connue ou n'impose aucune condition sur l'impédance de charge 8 et le niveau de compression du transistor 2.

Ce procédé de caractérisation selon le premier mode de réalisation de la présente invention comprend les étapes suivantes :

S1 : définition du point de polarisation (Vgs0, Vds0) ;
S2 : détermination de T, TRF, T1 et T2, et définition des bornes de N1 et N2 ;
S3 : définition de l'impédance de charge $Z_{LOAD}$ par :

- S31 : mesure du S22* à f0 ; et
- S32 : détermination de l'impédance de charge optimale $Z_{load, opt}$ (compromis entre niveau de compression minimal et amplitude de V2 maximale) ;

S4 : détermination de la première loi de variation ;
S5 : détermination de la seconde loi de variation ; et
S6 : mesure du réseau I-V en tenant compte de la variation dynamique de l'état des charges des pièges.

A minima, l'utilisateur doit connaître le point de polarisation (Vds0, Vgs0) de l'application finale du transistor 2 sous test. A l'étape S1, l'utilisateur définit le point de polarisation du transistor 2, correspondant à une tension grille-source de polarisation Vgs0 et à une tension drain-source de polarisation Vds0.

L'étape S2 du procédé permet tout d'abord de déterminer les valeurs de la période T et des durées TRF, T1 et T2 des impulsions 9, 10 et 11 en fonction de la mesure des constantes de temps des pièges dans le transistor 2 sur la grille 2a et le drain 2b du transistor 2, de manière à éviter tout effet cumulatif des effets de pièges lors des mesures.

Pour déterminer ces valeurs de T, TRF, T1 et T2, il doit être considéré que :

- La largeur des impulsions 9, 10 et 11 doit être suffisamment courte pour ne pas créer de phénomène d'auto-échauffement au niveau du transistor 2 (par exemple, une largeur d'impulsion d'1µs est suffisante).
- La période T doit être suffisamment grande pour ne pas avoir d'effet cumulatif lié au caractère transitoire des phénomènes de pièges. Pour cela, une étude est effectuée pour déterminer les constantes de temps des pièges. Cette étude se décompose en deux mesures dites « gate-lag » (mesure du retard d'établissement du courant de sortie lié à une impulsion sur la grille) et « drain-lag » (mesure du retard d'établissement du courant de sortie lié à une impulsion sur le drain).

A titre d'exemple, les conditions de mesure pour la mise en évidence du phénomène de « gate-lag » peuvent être :

- $V_{Ghigh}$ = Vp = -3,8V, $V_{Glow}$ = -8V et $V_D$ = 5V (où $V_{Ghigh}$ est le niveau haut de l'impulsion sur la grille, $V_{Glow}$ est le niveau bas de l'impulsion sur la grille, et $V_D$ est la tension de drain),
- Largeur d'impulsion : 10µs,
- Fenêtre d'acquisition : 1s.

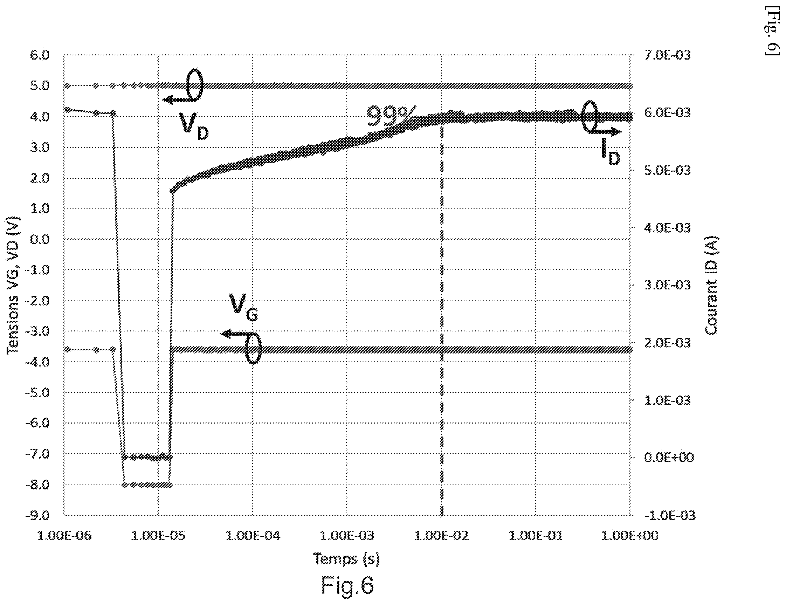

Dans ces conditions, comme illustré en Figure 6, l'évolution du courant de sortie $I_D$ montre bien que le phénomène de « gate-lag » apparait à partir de 20µs. Après une durée de 10ms, le courant $I_D$ à atteint environ 99% de sa valeur de départ (avant l'impulsion).

En outre, à titre d'exemple, les conditions de mesure pour la mise en évidence du phénomène de « drain-lag » peuvent être :

- $V_G$ = Vp = -3,8V, $V_{Dlow}$ = 10V et $V_{Dhigh}$ = 20V (où $V_G$ est la tension de grille, $V_{Dhigh}$ est le niveau haut de l'impulsion sur le drain, $V_{Dlow}$ est le niveau bas de l'impulsion sur le drain),
- Largeur d'impulsion : 10µs,
- Fenêtre d'acquisition : 200ms.

Dans ces conditions, l'évolution du courant de sortie $I_{OUT}$ montre bien le phénomène d'émission de « drain-lag ». Après une durée de 100ms, le courant $I_{OUT}$ a atteint environ 99% de sa valeur de départ (avant l'impulsion).

Ainsi, le phénomène de « drain-lag » est celui qui a la constante de temps la plus longue (100ms). Par conséquent, une période T de 300ms permet de s'assurer qu'il n'y a pas d'effets cumulatifs liés aux pièges.

Ensuite, dans l'étape S2, des mesures en mode DC I(V) sont effectuées sur le transistor 2 sous test afin de définir les bornes des niveaux variables N1 et N2 des deux impulsions DC 10 et 11.

Spécifiquement, la définition des bornes de N1 et N2 dans l'étape S2 comprend :

- définir les bornes inférieure et supérieure [Vgsmin ; Vgsmax] du premier niveau DC N1, où : Vgsmax est déterminée en mesurant le courant de grille I du transistor 2 en fonction de la tension DC Vgs appliquée à la grille 2a du transistor 2 pour une tension Vds nulle appliquée au drain 2b du transistor 2, puis en définissant Vgsmax comme étant la valeur de Vgs pour laquelle le courant de grille Ig atteint une valeur de seuil de courant prédéterminée ; et Vgsmin ≤ Vp où Vp est la tension de pincement du transistor 2 ; et
- définir les bornes inférieure et supérieure [Vdsmin ; Vdsmax] du second niveau N2, où Vdsmin = 0V et Vdsmax = 2 * Vds0.

A titre d'exemple, pour la détermination des bornes de N1 et N2 sur les accès de grille et de drain d'un transistor 2 en technologie HEMT GaN, il est utile, pour l'accès de grille, de connaître la tension de pincement Vp et de la tension de grille maximale.

Pour déterminer Vp, une mesure en mode DC du courant de sortie Ids en fonction de la tension de grille Vgs est effectuée, puis la transconductance $Gm = \dfrac{dIds}{dVgs}$ est calculée. En appliquant une régression linéaire dans la partie linéaire de Gm, la tension de pincement Vp est déterminée comme étant à l'intersection de cette courbe et de l'axe des abscisses lorsque Gm = 0S.

D'un point de vue pratique, il peut être intéressant de limiter le réseau I-V pour les valeurs de Vgs < Vp car le courant de drain sera principalement nul. Cependant, dans ce mode de réalisation particulier, une approche différente a été choisie qui consiste à fixer la valeur minimale sur la grille (Vgsmin) comme étant la tension symétrique de la valeur maximale (Vgsmax) par rapport à la tension de polarisation (Vgs0). Soit :

Vgsmin < Vgs0 < Vgsmax et |Vgsmin - Vgs0| = |Vgsmax -Vgs0|.

Pour déterminer Vgsmax, une mesure I-V en mode DC est effectuée à Vds = 0V et la caractéristique Ig = f(Vg) est tracée. Une condition d'arrêt est fixée lors de la mesure de sorte que le courant de grille ne dépasse pas un certain seuil (par exemple, 10mA qui est en dessous de la valeur maximale fixée à 2mA/doigt de grille, soit 16mA pour un composant à 8 doigts (2mA * 8 doigts de grille)). Ainsi, lorsqu'à titre d'exemple, on trouve Vgsmax = 1,4V pour un point de polarisation (Vgs0 = -3,2V, Vds0 = 20V), en appliquant les règles fixées précédemment, avec Vgs0 = - 3,2V et Vgsmax = 1,4V, on obtient :

```
Vgsmin = Vgs0 - |Vgsmax - Vgs0| = -3,2 - 4,6 = -7,8V.
```

Finalement, il a été décidé de limiter les valeurs minimale et maximale sur la tension de grille entre -7,6V (Vgsmin) < -3,2V (Vgs0) < 1,2V (Vgsmax), afin de limiter la tension inverse (Vgsmin) sur l'accès de grille et aussi d'avoir un pas constant de 0,4V pour Vgs lors de la mesure.

En ce qui concerne les excursions sur l'accès de drain, la règle suivant est établie :

```
Vdsmin = 0V < Vds0 = 20V < Vdsmax = 2*Vds0 = 40V.
```

Cette étape de détermination des bornes de la mesure I-V à double impulsion n'est pas spécifique à la technologie GaN et pourrait également être appliqué à d'autres technologies III-V (GaAs par exemple).

L'étape S3, qui est nécessaire lorsque l'impédance de charge 8 de l'application finale du transistor 2 n'est pas connue, permet ensuite de définir l'impédance de charge $Z_{LOAD}$ appliquée au drain 2b du transistor 2. Pour cela, dans la sous-étape S31, on mesure en régime petits signaux (RF impulsionnel/à onde entretenue), au point de polarisation, à l'aide de l'analyseur de réseau vectoriel 12, le conjugué du coefficient de réflexion de sortie S22 du transistor 2 à la fréquence f0, ce qui permet de déterminer une impédance de charge initiale correspondante, c'est-à-dire l'impédance de charge qui sert de point de départ à la recherche d'une impédance de charge optimale. Ainsi, l'impédance de charge initiale est déterminée par la mesure, en régime petits signaux, du coefficient de réflexion de sortie S22 au point de polarisation d'intérêt (dans cet exemple, -3,2V, 20V) à la fréquence d'intérêt f0 = 10GHz. Son conjugué S22* est ensuite

déduit (par exemple, **S22\* = 0,447∠89,53°**), ce qui permet d'obtenir l'impédance de charge initiale $Z_{LOAD, INIT}$ = 33,57 + 37,47i.

Ensuite, dans la sous-étape S32, une mesure en régime grands signaux (RF impulsionnel/à onde entretenue à Vgs0, Vds0) est effectuée en faisant varier l'amplitude du signal RF pour un ensemble d'impédances de charge autour de ladite impédance de charge initiale, et on détermine ensuite l'impédance de charge optimale $Z_{load, opt}$ pour laquelle l'excursion de V2 est maximale pour un niveau de compression minimal, puis on définit l'impédance de charge 8 comme étant égale à l'impédance de charge optimale déterminée $Z_{load, opt}$.

La première loi de variation est fonction de l'impédance de charge 8 du transistor 2 et est ainsi un compromis entre le niveau de compression et les excursions en tensions d'entrée V1 et de sortie V2 du composant. On cherche ainsi à maximiser les excursions des tensions d'entrée V1 et de sortie V2 du transistor 2 tout en minimisant le niveau de compression du transistor 2.

La mesure en régime grands signaux effectuée à l'étape S32 est une mesure dite « charge adaptative » ou « load-pull » pour laquelle on fait varier l'impédance de charge du composant ainsi que la puissance d'entrée RF (Pavs).

La mesure dite « load-pull » consiste à appliquer une rampe de puissance sur l'accès de grille du transistor 2 pour différentes conditions de charge de sortie à la fréquence d'intérêt f0. Il est à noter qu'il serait également possible de contrôler les impédances aux harmoniques (n*F0), sans s'écarter du cadre de la présente invention.

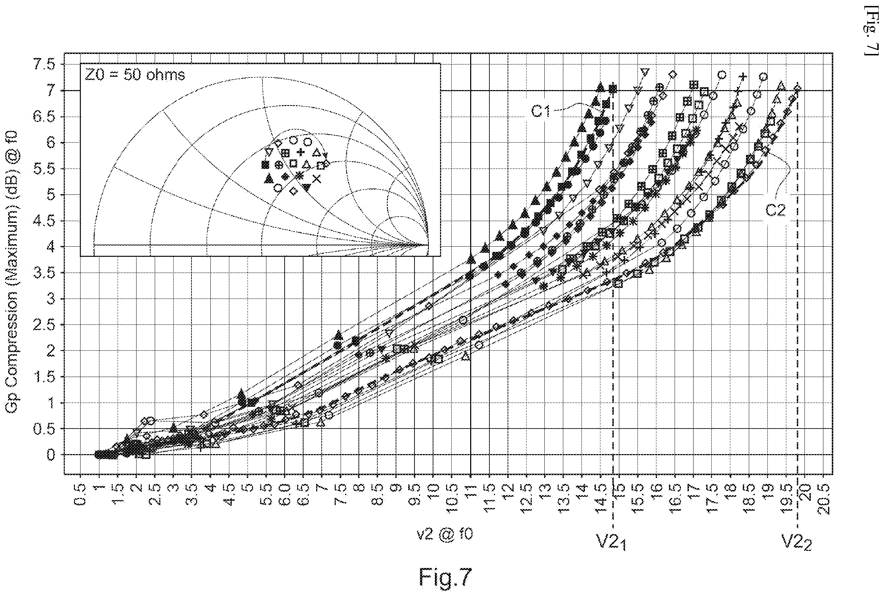

La Figure 7 montre, à titre d'exemple, les résultats de la mesure « load-pull » obtenus en grands signaux pour différentes impédances de charge (avec une puissance RF variant de -30dBm à 1,93dBm). L'encadré en haut à gauche de la Figure 7 représente un abaque de Smith montrant les différentes impédances de charge, autour de l'impédance de charge initiale, qui sont utilisées lors de la mesure « load-pull ». Les différentes courbes de la Figure 7 montrent, pour chacune des différentes impédances de charge autour de l'impédance de charge initiale, la caractéristique de compression de gain Gp (en dB à f0) du transistor 2 en fonction de l'excursion en tension de sortie V2. L'impédance de charge optimale $Z_{load, opt}$ est ensuite déterminée en choisissant la courbe de compression permettant d'obtenir le maximum d'excursion en tension de sortie V2 avec le minimum de compression, et permettant donc de couvrir l'aire de mesure la plus grande.

Par exemple dans la Figure 7, la courbe C1 permet d'obtenir un maximum d'excursion en tension de sortie $V2_1$ = 14,8V pour une compression de 7 dB, alors que la courbe C2 permet d'obtenir un maximum d'excursion en tension de sortie $V2_2$ = 19,8V pour une compression de 7 dB. Dans cet exemple, l'impédance de charge correspondant à la courbe C2 est ainsi choisie en tant qu'impédance de charge optimale (à savoir, $Z_{LOAD, OPT}$ = 48,7 + 79,7i).

Ensuite, dans l'étape S4, la première loi de variation est déterminée avec l'impédance de charge optimale $Z_{LOAD, OPT}$ comme impédance de charge 8.

Dans l'étape S4, on mesure la courbe de variation de l'excursion en tension de grille V1 en fonction de la puissance Pavs émise dans une impulsion RF à f0, puis on définit différents niveaux de puissance Pavs1, ..., Pavsn de l'impulsion RF par découpe de ladite courbe de variation de V1, chaque niveau de puissance Pavs1, ..., Pavsn correspondant à une certaine plage de la tension V1, puis on mesure la courbe de variation de l'excursion en tension de grille V1 en fonction de l'excursion en tension de drain V2 de manière à déterminer les couples possibles de valeurs (N1, N2) et, pour chaque couple (N1, N2), le niveau de puissance NRF correspondant à appliquer à la pré-impulsion RF 9 parmi les différents niveaux de puissance Pavs1, ..., Pavsn.

Ainsi, à chaque période T, le niveau de puissance NRF de la pré-impulsion RF 9 est l'un parmi les différents niveaux de puissance Pavs1, ..., Pavsn, et est choisi en fonction des niveaux N1 et N2 qui seront appliqués aux deux impulsions DC 10 et 11 dans la même période T. La première loi de variation prend ainsi en compte la zone explorée du réseau I-V du transistor 2 pour fixer le niveau de puissance NRF de la pré-impulsion RF 9 dans la période T en question. Ainsi, pour chaque zone, et donc pour chaque niveau de puissance Pavs, les excursions en tension V1 et V2 par rapport au point de polarisation changent.

A titre d'exemple, les différents niveaux de puissance Pavs1, ..., Pavsn peuvent être définis en découpant la courbe de variation de V1 à pas de V1 constant (par exemple, pas de 0,4V).

Dans l'idéal, le niveau de puissance NRF de la pré-impulsion RF 9 devrait évoluer de manière continue afin que la transition d'une aire de mesure à une autre soit la plus représentative possible de l'évolution de l'amplitude du signal. Dans la pratique, un nombre déterminé de niveaux de puissance Pavs1, ..., Pavsn est défini.

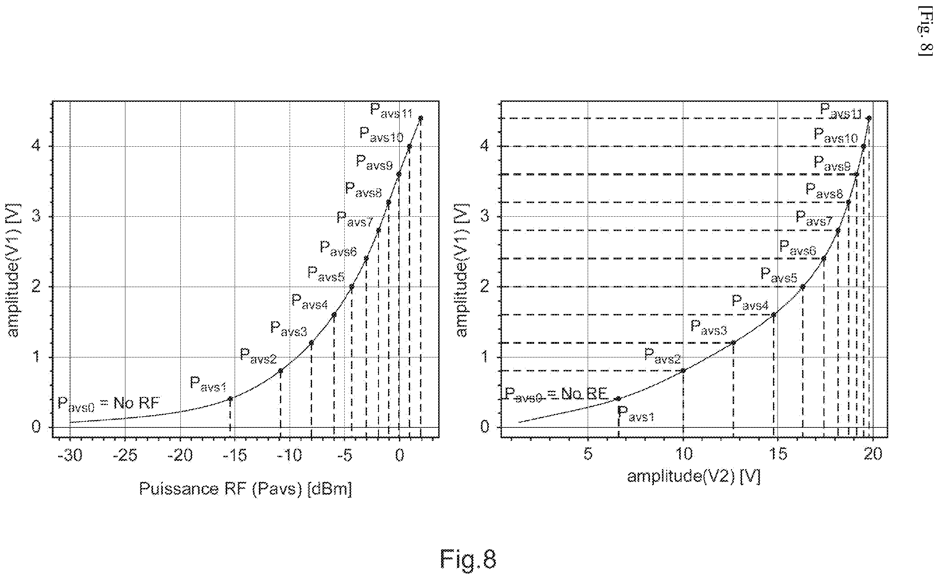

La Figure 8 représente, à titre d'exemple, sur la gauche, le résultat de la mesure de l'évolution de l'amplitude de la tension V1 en fonction de la puissance RF Pavs, et, sur la droite, le résultat de la mesure de l'évolution de l'amplitude de la tension V1 en fonction de l'amplitude de la tension V2. La courbe de droite de la Figure 8 donne ainsi la correspondance des niveaux d'amplitude V2 pour chaque niveau de Pavs et donc chaque niveau de V1.

Le découpage des différents niveaux de puissance Pavs1, ..., Pavs11 présentés dans cet exemple est pour avoir un pas en tension d'entrée (V1) constant de 0,4V. D'autres approches sont possibles en fonction des besoins. Par exemple, une découpe pour un pas en tension non linéaire de la tension d'entrée.

Chargé sur l'impédance de charge optimale déterminée précédemment ($Z_{LOAD, OPT}$ = 48,7 + 79,7i), le système est ainsi capable d'atteindre des excursions en tension d'entrée V1 de +/-4,4 V et en tension de sortie V2 de +/-19,8 V, ce qui correspond à des niveaux d'entrée (N1) compris entre -7,6V et 1,2V (-3,2V +/-4,4V) et à des niveaux de sortie (N2) compris entre 0,2V et 39,8V (20V +/-19,8V).

Le niveau de puissance RF évolue en fonction de la zone du réseau I-V explorée. Pour chaque zone, et donc pour chaque niveau de puissance Pavs, les excursions en tension V1 et V2 changent.

Le Tableau 1 ci-dessous montre un récapitulatif des différents niveaux de Pavs (Pavs1, ..., Pavs11) en fonction des excursions en tensions d'entrée (N1) et de sortie (N2) impulsionnelles. Dans cet exemple, 11 niveaux de puissance Pavs1, ..., Pavs11 sont définis (12 si l'on considère le premier point de mesure à -3.2V, 20V pour lequel la puissance RF Pavs0 de la pré-impulsion RF 9 est nulle). A titre d'exemple, pour Pavs5, le niveau de puissance NRF de la pré-impulsion RF 9 est de -4,34 dBm, ce qui correspond à des excursions en tension DC impulsionnelle comprises entre -5,2V et -1,2V (-3,2V +/- 2V) en entrée (N1) et comprises entre 3,66V et 36,34V (20V +/-16,4V) en sortie (N2).

Tableau 1

| Pavs | | V1(V) | N1 (V) | | V2 (V) | N2 (V) | |
|---|---|---|---|---|---|---|---|
| # | dBm | | min. | max. | | min. | max. |
| 0 | Pas de RF | 0,00 | -3,20 | -3,20 | 0,00 | 20,00 | 20,00 |
| 1 | -15,47 | 0,40 | -3,60 | -2,80 | 6,66 | 13,34 | 26,66 |
| 2 | -10,84 | 0,80 | -4,00 | -2,40 | 10,02 | 9,98 | 30,02 |
| 3 | -8,02 | 1,20 | -4,40 | -2,00 | 12,62 | 7,38 | 32,62 |
| 4 | -5,93 | 1,60 | -4,80 | -1,60 | 14,75 | 5,25 | 34,75 |
| 5 | -4,34 | 2,00 | -5,20 | -1,20 | 16,34 | 3,66 | 36,34 |
| 6 | -3,06 | 2,40 | -5,60 | -0,80 | 17,40 | 2,60 | 37,40 |
| 7 | -1,96 | 2,80 | -6,00 | -0,40 | 18,13 | 1,87 | 38,13 |
| 8 | -0,96 | 3,20 | -6,40 | 0,00 | 18,73 | 1,27 | 38,73 |
| 9 | -0,03 | 3,60 | -6,80 | 0,40 | 19,15 | 0,85 | 39,15 |
| 10 | 0,93 | 4,00 | -7,20 | 0,80 | 19,52 | 0,48 | 39,52 |
| 11 | 1,93 | 4,40 | -7,60 | 1,20 | 19,78 | 0,22 | 39,78 |

Par la suite la seconde loi de variation peut être déterminée à l'étape S5 dans laquelle, pour au moins la première période T, V1 = 0 et V2 = 0 (c'est-à-dire, N1 = Vgs0, N2 = Vds0 et NRF = Pavs0) et, pour les périodes T suivantes, V1 et V2 sont choisis de telle sorte que, sur l'ensemble des périodes T, N1 et N2 varient autour du point de polarisation (Vgs0, Vds0) tout en s'éloignant progressivement de ce dernier. Ainsi, le réseau I-V du transistor 2 est exploré de telle sorte que, sur la totalité des périodes T du procédé, la variation du couple (N1, N2) autour du point de polarisation forme une spirale représentant le cycle de charge du composant soumis à une rampe de puissance.

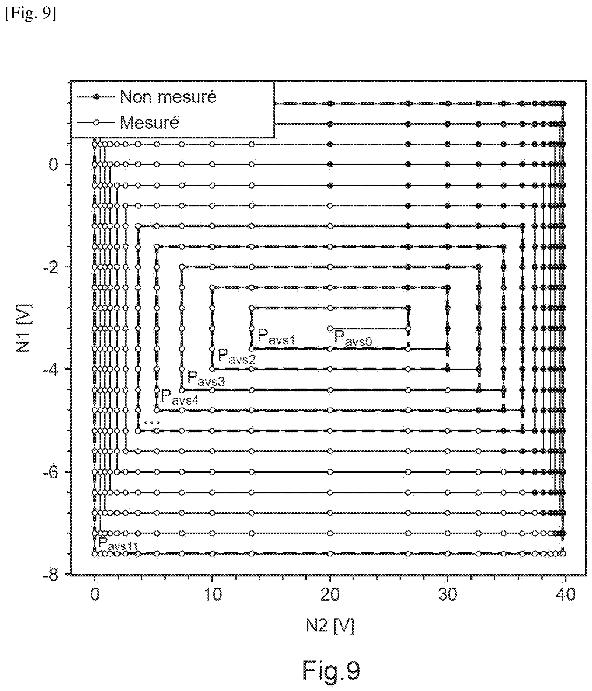

Comme représenté en Figure 9, au point de polarisation (N1 = Vgs0, N2 = Vds0), le niveau de puissance RF est nulle (Pavs0) puis, au fur et à mesure de la séquence de mesure, les niveaux N1 et N2 des impulsions DC 10 et 11 augmentent et décrivent une spirale autour du point de polarisation, à la manière du cycle de charge réel du composant. Aussi, le niveau de puissance NRF de la pré-impulsion RF 9 augmente de manière incrémentale (Pavs1, Pavs2, ..., Pavs11) au fur et à mesure de la séquence de mesure.

Contrairement à la méthode dite classique généralement utilisée pour mesurer un réseau I-V à partir d'un système à simple impulsion (consistant à faire varier la tension de sortie (Vds) lorsque la tension d'entrée (Vgs) est fixe et à recommencer la procédure pour différentes valeurs de Vgs (l'inconvénient de cette méthode étant qu'elle n'est pas représentative de l'évolution du signal réel autour du point de polarisation)), le procédé de la présente invention permet de décrire le réseau I-V en tournant autour du point de polarisation, à la manière d'un cycle de charge. Au fur et à mesure que la puissance RF NRF augmente, les niveaux N1 et N2 s'écartent de plus en plus du point de polarisation afin de balayer l'ensemble du réseau I-V.

La Figure 9 montre l'évolution des tensions impulsionnelles DC en entrée (N1) et en sortie (N2). La séquence de mesure est représentée par la ligne pleine reliant les différents points de mesure du réseau I-V. Chaque zone en pointillé est mesurée pour un niveau de puissance donné parmi Pavs1, ..., Pavs11. Comme indiqué précédemment, la première mesure au point de polarisation (-3,2V, 20V) est réalisée à Pavs nulle (Pavs0).

L'ensemble des points de mesure (points blancs et points noirs) sur la Figure 9 représente la séquence totale théorique de la mesure I-V réalisée à l'étape S6. Cependant, une limitation en tension est fixée afin de ne pas détruire le transistor 2 durant la mesure. Ainsi, seuls les points blancs sont réellement mesurés lors de l'étape S6 du procédé.

Il est à noter qu'en cas d'application multi-polarisation, le procédé est répété pour les différents points de polarisation.

Le séquençage de la seconde loi de variation consiste ainsi à délimiter des zones du réseau I-V pour lesquelles la puissance d'entrée Pavs et donc le niveau NRF de la pré-impulsion RF 9 sont fixes, ledit niveau NRF augmentant de manière incrémentale (Pavs1, Pavs2, **...** Pavs11) lors de la mesure.

Pendant la durée de mesure TM, le courant de drain $I_{OUT}$, la tension de grille $V_G$, la tension de drain $V_D$ et le courant de grille du transistor 2 peuvent être mesurés.

La mesure des tensions de grille $V_G$ et de drain $V_D$ permet de vérifier si ces deux tensions sont ou non arrivées au niveau des consignes N1 et N2 et de réaliser un asservissement jusqu'à l'atteinte des consignes (c'est-à-dire que le même couple (N1, N2) (à savoir, l'un des points de mesure dans le séquençage de la Figure 9) est appliqué pendant plusieurs périodes T jusqu'à ce que cette consigne soit atteinte), ensuite le courant de drain est mesuré sur un nombre prédéfini (par exemple, 10) de périodes T puis moyenné.

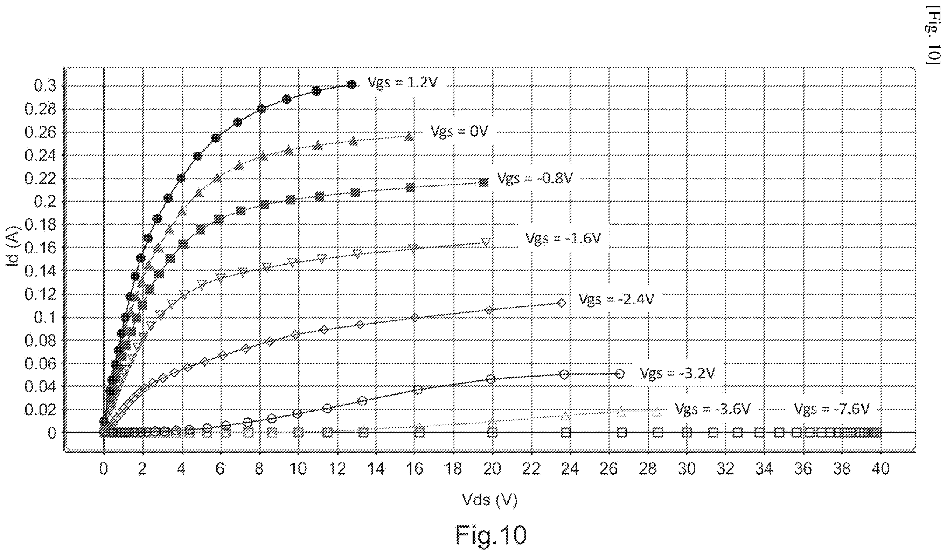

La Figure 10 représente un réseau I-V à titre d'exemple du transistor 2, mesuré à l'aide du procédé de caractérisation selon la présente invention.

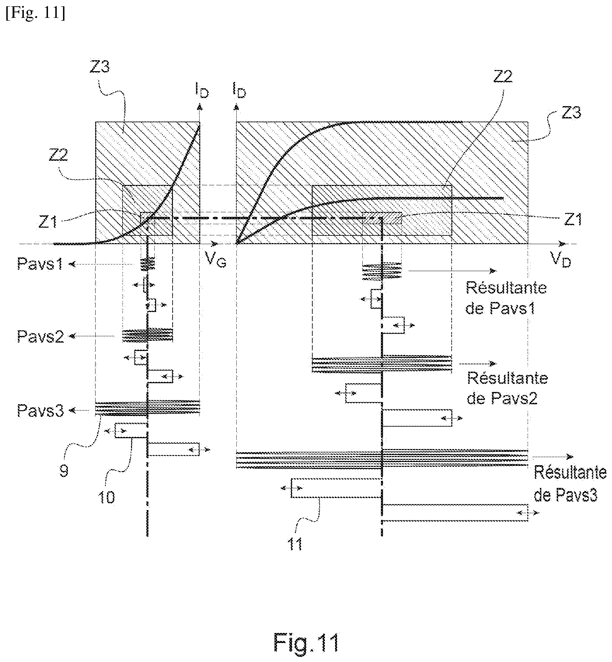

Si l'on se réfère à la Figure 11, on peut voir qu'il y est représenté un chronogramme à titre d'exemple de l'étape de mesure S6 du procédé selon le premier mode de réalisation et les courbes $I_D(V_G)$ et $I_D(V_D)$ résultantes (où $I_D$ est le courant de drain) du réseau I-V mesuré, avec trois zones de mesure Z1, Z2 et Z3 du réseau I-V correspondant respectivement à trois niveaux de puissance RF différents Pavs1, Pavs2 et Pavs3 de la pré-impulsion RF 9.

Pour chaque période T, la pré-impulsion RF 9 est appliquée sur la grille 2a du transistor 2 avec un niveau de puissance NRF défini selon la première loi de variation prédéterminée (parmi Pavs1, Pavs2 et Pavs3), de manière à fixer l'état de charge des pièges dans le transistor 2. Un signal RF résultant est alors généré sur le drain 2b du transistor 2.

Ensuite, pour chaque période T, la première impulsion DC 10 est appliquée sur la grille 2a du transistor 2 et la seconde impulsion DC 11 est appliquée sur le drain 2b du transistor 2, le premier niveau DC N1 et le second niveau DC N2 des deux impulsions DC 10 et 11 étant définis selon la seconde loi de variation prédéterminée (par exemple, selon un séquençage similaire à celui de la Figure 9). Pour chaque niveau de puissance RF (Pavs1, Pavs2, Pavs3) est associée une puissance RF résultante délimitant ainsi les trois zones Z1, Z2 et Z3 à niveau de puissance constant et à état de charge des pièges fixe.

Afin de maintenir constant l'état de charge des pièges, il est indispensable que les niveaux des tensions DC impulsionnelles N1 et N2, servant à balayer le réseau I-V, ne dépassent pas les niveaux de puissance Pavs1, Pavs2 et Pavs3. En d'autres termes à chaque niveau de puissance (Pavs1, Pavs2, Pavs3) les excursions en entrée V1 et en sortie V2 seront contenus dans les zones délimitées par la pré-impulsion RF 9 et sa résultante.

A partir du point de polarisation (correspondant au centre de la zone Z1), la zone Z1 correspondant au niveau de puissance Pavs1 est tout d'abord explorée en faisant varier N1 et N2 dans cette zone Z1, puis la zone Z2 correspondant au niveau de puissance Pavs2 est explorée en faisant varier N1 et N2 dans cette zone Z2, puis la zone Z3 correspondant au niveau de puissance Pavs3 est explorée en faisant varier N1 et N2 dans cette zone Z3.

On peut voir que le choix, à l'étape S3, de l'impédance de charge optimale $Z_{load,\ opt}$ en tant qu'impédance de charge 8 permet de couvrir entièrement le réseau I-V du transistor 2 sous test.

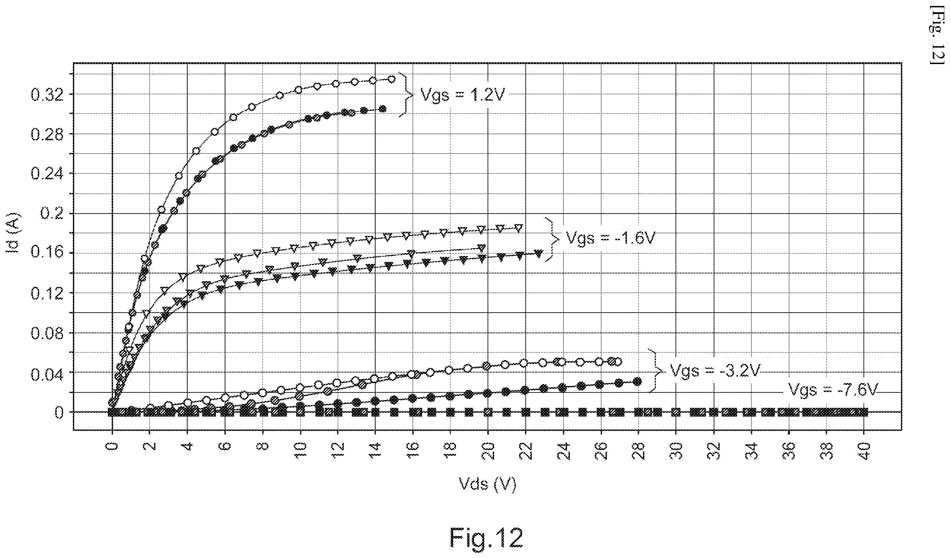

Si l'on se réfère à la Figure 12, on peut voir qu'il y est représenté un comparatif des réseaux I-V obtenus avec trois techniques de mesure différentes, à savoir la technique existante à simple impulsion (courbes avec les symboles blancs), la technique existante à double impulsion avec pré-impulsion RF à niveau fixe et maximale (courbes avec les symboles noirs), et le procédé de caractérisation selon la présente invention avec une pré-impulsion RF à niveau variable (courbes avec les symboles gris).

On constate ainsi que :

- Pour le réseau I-V à simple impulsion, le courant est globalement plus important par rapport aux autres réseaux I-V. Cela est dû au fait que l'état de charge des pièges est sous-estimé car fixé principalement par le point de polarisation.
- Pour le réseau I-V à double impulsion avec pré-impulsion RF de niveau fixe et maximale, l'état de charge des pièges est bien pris en compte à fort Vgs (Vgs = 1,2V). Cependant, à faible Vgs (Vgs = -3,2V), le niveau de courant est sous-estimé, car le niveau de pièges est trop important.
- Avec le procédé de caractérisation selon la présente invention à pré-impulsion RF à niveau variable, l'état de charge des pièges est bien pris en compte quelles que soient les tensions Vgs et Vds. A faible puissance, l'état de charge des pièges est principalement fixé par le point de polarisation. Plus le niveau du signal RF augmente et plus le niveau de pièges croît, entrainant une diminution significative du courant.

La technique de mesure selon la présente invention, basée sur l'utilisation d'une pré-impulsion RF de niveau variable associée à une séquence de mesure des points du réseau I-V spécifique permet ainsi de contrôler dynamiquement l'état de charge des pièges et d'obtenir la caractéristique I-V réaliste du transistor 2.

Il est à noter que l'ajout de signaux RF aux harmoniques et l'adaptation de la loi de variation de la pré-impulsion RF sur une plus large bande de fréquences pourraient également être effectués, sans s'écarter du cadre de la présente invention. Cela permettrait en effet d'affiner la forme du cycle de charge et serait davantage représentatif de son fonctionnement.

Il est également à noter que la mesure des paramètres en petits signaux (paramètres S) pourrait également être effectuée pendant la mesure de la caractéristique I-V, sans s'écarter du cadre de la présente invention. En effet, l'utilisation de l'analyseur de réseau vectoriel 12 à 4 ports permet la mesure supplémentaire des paramètres S pendant la durée TMRF.

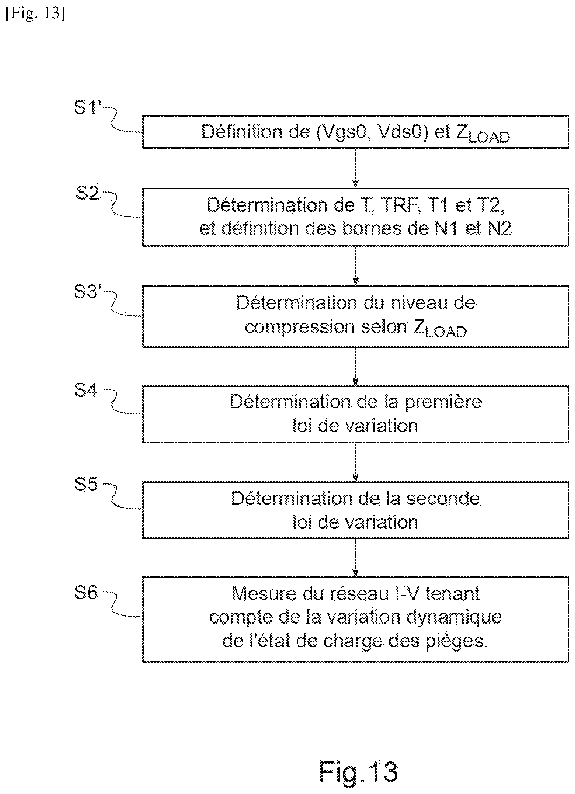

Si l'on se réfère à la Figure 13, on peut voir qu'il y est représenté l'organigramme d'un procédé de caractérisation selon un second mode de réalisation de la présente invention, à savoir dans le cas où l'application finale du transistor 2 sous test et l'impédance de charge 8 associée sont connues.

Ce procédé de caractérisation selon le second mode de réalisation est identique à celui du premier mode de réalisation (représenté en Figure 5) à l'exception du fait que :

- l'étape S1 de la Figure 5 est remplacée par l'étape S1' : définition du point de polarisation et de l'impédance de charge $Z_{LOAD}$, et
- l'étape S3 de la Figure 5 est remplacée par l'étape S3' : détermination du niveau de compression associé à l'impédance de charge $Z_{LOAD}$.

A l'étape S1', l'impédance de charge $Z_{LOAD}$ est définie par l'utilisateur en fonction de l'application finale du transistor 2 sous test.

A l'étape S3', le niveau de compression du transistor 2 est imposé par l'impédance de charge $Z_{LOAD}$ définie à l'étape S1', ce qui permet ensuite de déterminer la première loi de variation de la pré-impulsion RF à l'étape S4.

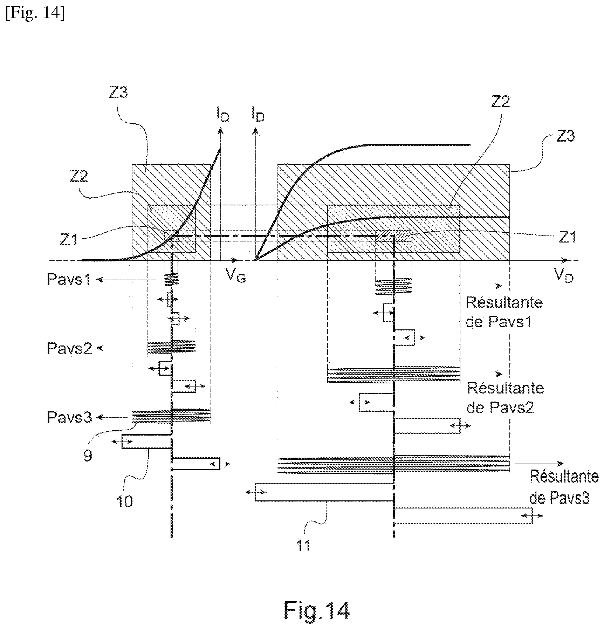

Si l'on se réfère à la Figure 14, on peut voir qu'il y est représenté un chronogramme à titre d'exemple de l'étape de mesure S6 du procédé selon le second mode de réalisation et les courbes $I_D(V_G)$ et $I_D(V_D)$ résultantes du réseau I-V mesuré, avec trois zones de mesure Z1, Z2 et Z3 du réseau I-V correspondant respectivement à trois niveaux de puissance RF différents Pavs1, Pavs2 et Pavs3 de la pré-impulsion RF 9.

Comparé au premier mode de réalisation (représenté en Figure 11), étant donné que dans le second mode de réalisation l'impédance de charge 8 et le niveau de compression sont imposés par l'application finale, la dernière zone Z3 (correspondant au dernier niveau de puissance Pavs3) du second mode de réalisation ne permet pas de couvrir la totalité du réseau I-V. Dans ce cas, l'amplitude des impulsions DC 10 et 11 peut être supérieure à l'amplitude du signal RF dans cette zone Z3, de manière à rendre possible la mesure de la totalité du réseau I-V sans crainte de détériorer le transistor 2 sous test.

Il est bien entendu que les modes de réalisation particuliers qui viennent d'être décrits ont été donnés à titre indicatif et non limitatif, et que des modifications peuvent être apportées sans que l'on s'écarte pour autant de la présente invention.

**Revendications**

1. Procédé de caractérisation en mode impulsionnel d'un transistor (2) à semi-conducteur III-V, le transistor (2) comprenant une grille (2a), un drain (2b) et une source (2c), dans lequel ledit procédé comprend les étapes suivantes :

   a) définir (S1 ; S1') un point de polarisation du transistor (2) correspondant à une tension grille-source de polarisation Vgs0 et à une tension drain-source de polarisation Vds0 ;
   b) définir (S3 ; S1') une impédance de charge (8) appliquée au drain (2b) du transistor (2) ;

   **caractérisé en ce que** ledit procédé comprend en outre les étapes suivantes :
   c) définir une période T, et pour chaque période T :

   - c1) appliquer une pré-impulsion radiofréquence, RF, (9) sur la grille (2a) du transistor (2) de manière à fixer l'état de charge des pièges dans le transistor (2), ladite pré-impulsion RF (9) ayant une fréquence f0 prédéfinie, une durée de pré-impulsion TRF prédéfinie et un niveau de puissance NRF défini selon une première loi de variation prédéterminée ;
   - c2) après la pré-impulsion RF (9), appliquer une première impulsion à courant continu, DC, (10) sur la grille (2a) du transistor (2) et une seconde impulsion DC (11) sur le drain (2b) du transistor (2), la première impulsion DC (10) ayant une première durée T1 et la seconde impulsion DC (11) ayant une seconde durée T2, les première et seconde durées T1, T2 étant au moins partiellement simultanées, la première impulsion DC (10) et la seconde impulsion DC (11) ayant, respectivement, un premier niveau DC N1 et un second niveau DC N2 définis selon une seconde loi de variation prédéterminée ; et

- c3) pendant une durée de mesure TM pendant l'application simultanée des première et seconde impulsions DC (10, 11), mesurer (S6) le courant Id circulant dans le drain (2b) du transistor (2) ;

dans lequel, pour chaque période T, dans la première loi de variation, le niveau de puissance NRF de la pré-impulsion RF (9) dépend des premier N1 et second N2 niveaux DC des première et seconde impulsions DC (10, 11) appliquées ultérieurement dans la même période T ;

dans lequel, pour chaque période T, dans la seconde loi de variation, le premier niveau DC N1 est égal à Vgs0 plus une première valeur V1 définie par la seconde loi de variation en fonction de la période T actuelle, et le second niveau DC N2 est égal à Vds0 plus une seconde valeur V2 définie par la seconde loi de variation en fonction de la période T actuelle, les première V1 et seconde V2 valeurs étant des nombres réels.

2. Procédé de caractérisation selon la revendication 1, **caractérisé par le fait qu'**il comprend en outre, entre les étapes a) et b), une étape de détermination (S2) de la période T et des durées TRF, T1 et T2 en fonction de la mesure des constantes de temps des pièges dans le transistor (2) sur la grille (2a) et sur le drain (2b) du transistor (2).

3. Procédé de caractérisation selon la revendication 1 ou 2, **caractérisé par le fait qu'**il comprend en outre, entre les étapes a) et b) :

d1) définir (S2) les bornes inférieure et supérieure [Vgsmin ; Vgsmax] du premier niveau DC N1 dans la seconde loi de variation, où :

Vgsmax est déterminée en mesurant le courant de grille Ig du transistor (2) en fonction de la tension DC Vgs appliquée à la grille (2a) du transistor (2) pour une tension Vds nulle appliquée au drain (2b) du transistor (2), puis en définissant Vgsmax comme étant la valeur de Vgs pour laquelle le courant de grille Ig atteint une valeur de seuil de courant prédéterminée ; et

Vgsmin ≤ Vp où Vp est la tension de pincement du transistor (2) ; et

d2) définir (S2) les bornes inférieure et supérieure [Vdsmin ; Vdsmax] du second niveau DC N2 dans la seconde loi de variation, où Vdsmin = 0V et Vdsmax = 2 * Vds0.

4. Procédé de caractérisation selon l'une des revendications 1 à 3, **caractérisé par le fait qu'**il comprend en outre, entre les étapes b) et c), une étape de détermination de la première loi de variation (S4) comprenant :

e1) pour l'impédance de charge (8) définie appliquée sur le drain (2b) du transistor (2), mesurer l'amplitude de Vgs au cours du temps à f0 ou à une harmonique de f0 en fonction de la puissance Pavs émise dans une impulsion RF à f0 ou à une harmonique de f0, puis définir différents niveaux de puissance Pavs1, ..., Pavsn de l'impulsion RF par découpe de la courbe de variation de l'amplitude mesurée de Vgs en fonction de la puissance Pavs, chaque niveau de puissance Pavs1, ..., Pavsn correspondant à une certaine plage de la tension Vgs ;

e2) pour l'impédance de charge (8) définie, mesurer la courbe de variation de la tension Vgs en fonction de la tension Vds de manière à déterminer des couples possibles de valeurs (N1, N2) ; et

e3) pour chaque couple possible de valeurs (N1, N2), déterminer le niveau de puissance NRF correspondant à appliquer à la pré-impulsion RF (9) parmi les différents niveaux de puissance Pavs1, ..., Pavsn.

5. Procédé de caractérisation selon l'une des revendications 1 à 4, **caractérisé par le fait que**, dans l'étape b), l'impédance de charge (8) est définie (S1') par l'utilisateur en fonction de l'application finale, ce qui définit (S3') une contrainte sur le niveau de compression du transistor (2).

6. Procédé de caractérisation selon l'une des revendications 1 à 4, **caractérisé par le fait que** l'étape de définition de l'impédance de charge b) comprend :

mesurer (S31), au point de polarisation, le conjugué du coefficient de réflexion de sortie S22 du transistor (2) à la fréquence f0 et déterminer une impédance de charge initiale correspondante ;

effectuer (S32) une mesure cumulant un balayage en puissance avec une variation de l'impédance de charge autour de ladite impédance de charge initiale afin de déterminer l'impédance de charge optimale pour laquelle l'excursion de la tension Vds est maximale pour un niveau de compression minimal ; et

définir l'impédance de charge (8) comme étant égale à l'impédance de charge optimale déterminée.

7. Procédé de caractérisation selon l'une des revendications 1 à 6, **caractérisé par le fait qu'**il comprend en outre, entre les étapes b) et c), une étape de détermination de la seconde loi de variation (S5) comprenant :

f1) pour au moins la première période T, définir V1 = 0 et V2 = 0 ; et
f2) pour chacune des périodes T suivantes, définir V1 et V2 de telle sorte que, sur l'ensemble des périodes T, N1 et N2 varient autour du point de polarisation tout en s'éloignant progressivement de ce dernier.

8. Procédé de caractérisation selon l'une des revendications 1 à 7, **caractérisé par le fait qu'**il comprend en outre, à chaque période T, la mesure des paramètres S sur la grille (2a) et le drain (2b) du transistor (2) pendant l'application des première et seconde impulsions DC (10, 11).

9. Procédé de caractérisation selon l'une des revendications 1 à 8, **caractérisé par le fait que** l'étape c3) comprend en outre : pendant la durée de mesure TM, mesurer la tension de grille, la tension de drain et le courant de grille du transistor (2).

10. Banc de mesures (1) pour la caractérisation en mode impulsionnel d'un transistor (2) à semi-conducteur III-V, le banc de mesure (1) comprenant un générateur RF impulsionnel (3), une première source de tension DC impulsionnelle (4) associée à un premier multimètre configuré pour mesurer des tensions et courants, une seconde source de tension DC impulsionnelle (5) associée à un second multimètre configuré pour mesurer des tensions et courants, un premier té de polarisation (6) et un second té de polarisation (7), le générateur RF impulsionnel (3) et la première source de tension DC impulsionnelle (4) étant configurées pour être reliées à la grille (2a) du transistor (2) par l'intermédiaire du premier té de polarisation (6), la seconde source de tension DC impulsionnelle (5) et une impédance de charge (8) étant configurées pour être reliées au drain (2b) du transistor (2) par l'intermédiaire du second té de polarisation (7), le banc de mesures (1) comprenant en outre un dispositif de commande configuré pour commander le générateur RF impulsionnel (3), la première source de tension DC impulsionnelle (4) et la seconde source de tension DC impulsionnelle (5) de manière à réaliser le procédé de caractérisation selon l'une des revendications 1 à 9.

11. Banc de mesures (1) selon la revendication 10, **caractérisé par le fait qu'**il comprend en outre un analyseur de réseau vectoriel (12) configuré pour être relié à la grille (2a) et au drain (2b) du transistor (2) par l'intermédiaire de coupleurs (13, 14).

12. Banc de mesures (1) selon la revendication 10 ou 11, **caractérisé par le fait qu'**il comprend en outre au moins deux wattmètres configurés pour être reliés à la grille (2a) et au drain (2b) du transistor (2) par l'intermédiaire de coupleurs.

**Patentansprüche**

1. Verfahren zur Charakterisierung eines Halbleiter-III-V-Transistors (2) im Impulsmodus, wobei der Transistor (2) ein Gate (2a), einen Drain (2b) und eine Source (2c) umfasst, wobei das Verfahren die folgenden Schritte umfasst:

a) Definieren (S1; S1') eines Polarisationspunkts des Transistors (2), der einer Gate- Source-Polarisationsspannung Vgs0 und einer Drain-Source-Polarisationsspannung Vds0 entspricht;
b) Definieren (S3; S1') einer an den Drain (2b) des Transistors (2) angelegten Lastimpedanz (8);

**dadurch gekennzeichnet, dass** das Verfahren ferner die folgenden Schritte umfasst:
c) Definieren eines Zeitraums T, und für jeden Zeitraum T:

- c1) Anlegen eines Hochfrequenz, RF,-Vorimpulses (9) an das Gate (2a) des Transistors (2), um den Ladezustand der Fallen im Transistor (2) zu fixieren, wobei der RF-Vorimpuls (9) eine vordefinierte Frequenz f0, eine vordefinierte Vorimpulsdauer TRF und einen Leistungspegel NRF aufweist, der nach einem ersten vorbestimmten Änderungsgesetz definiert ist;
- c2) nach dem RF-Vorimpuls (9), Anlegen eines ersten Gleichstromimpulses, DC, (10) an das Gate (2a) des Transistors (2) und einen zweiten DC-Impulses (11) an den Drain (2b) des Transistors (2), wobei der erste DC-Impuls (10) eine erste Dauer T1 aufweist und der zweite DC-Impuls (11) eine zweite Dauer T2 aufweist, wobei die erste und die zweite Dauer T1, T2 mindestens teilweise gleichzeitig sind, wobei der erste DC-Impuls (10) und der zweite DC-Impuls (11) jeweils einen ersten DC-Pegel N1 und einen zweiten DC-Pegel N2 aufweisen, die nach einem zweiten vorbestimmten Änderungsgesetz definiert sind; und
- c3) während einer Messdauer TM während des gleichzeitigen Anlegens des ersten und des zweiten DC-Impulses (10, 11), Messen (S6) des im Drain (2b) des Transistors (2) fließenden Stroms Id;

wobei für jeden Zeitraum T in dem ersten Änderungsgesetz der Leistungspegel NRF des RF-Vorimpulses (9) von dem ersten N1 und dem zweiten N2 DC-Pegel des ersten und des zweiten DC-Impulses (10, 11) abhängt, die später in demselben Zeitraum T angelegt werden;

wobei für jeden Zeitraum T in dem zweiten Änderungsgesetz der erste DC-Pegel N1 gleich Vgs0 plus einem ersten Wert V1 ist, der durch das zweite Änderungsgesetz in Abhängigkeit von dem aktuellen Zeitraum T definiert ist, und der zweite DC-Pegel N2 gleich Vds0 plus einem zweiten Wert V2 ist, der durch das zweite Änderungsgesetz in Abhängigkeit von dem aktuellen Zeitraum T definiert ist, wobei der erste V1 und der zweite V2 Wert reale Zahlen sind.

2. Charakterisierungsverfahren nach Anspruch 1, **dadurch gekennzeichnet, dass** es ferner zwischen den Schritten a) und b) einen Schritt des Bestimmens (S2) des Zeitraums T und der Dauern TRF, T1 und T2 in Abhängigkeit von der Messung der Zeitkonstanten der Fallen im Transistor (2) an dem Gate (2a) und an dem Drain (2b) des Transistors (2) umfasst.

3. Charakterisierungsverfahren nach Anspruch 1 oder 2, **dadurch gekennzeichnet, dass** es zwischen den Schritten a) und b) ferner umfasst:

d1) Definieren (S2) der unteren und der oberen Grenze [Vgsmin; Vgsmax] des ersten DC-Pegels N1 im zweiten Änderungsgesetz, wobei:

Vgsmax bestimmt wird, indem der Gate-Strom Ig des Transistors (2) in Abhängigkeit von der am Gate (2a) des Transistors (2) angelegten DC-Spannung Vgs bei einer an den Drain (2b) des Transistors (2) angelegten Nullspannung Vds gemessen wird, und dann indem Vgsmax als Wert von Vgs definiert wird, bei dem der Gate-Strom Ig einen vorbestimmten Stromschwellenwert erreicht; und
Vgsmin $\leq$ Vp, wobei Vp die Pinch-off-Spannung des Transistors (2) ist; und

d2) Definieren (S2) der unteren und der oberen Grenze [Vdsmin; Vdsmax] des zweiten DC-Pegels N2 im zweiten Änderungsgesetz, wobei Vdsmin = 0V und Vdsmax = 2 * Vds0.

4. Charakterisierungsverfahren nach einem der Ansprüche 1 bis 3, **dadurch gekennzeichnet, dass** es ferner zwischen den Schritten b) und c) einen Schritt des Bestimmens des ersten Änderungsgesetzes (S4) umfasst, umfassend:

e1) für die definierte Lastimpedanz (8), die an den Drain (2b) des Transistors (2) angelegt ist, Messen der Amplitude von Vgs im Zeitverlauf bei f0 oder bei einer Oberschwingung von f0 in Abhängigkeit von der in einem RF-Impuls bei f0 oder bei einer Oberschwingung von f0 ausgesandten Leistung Pavs, und dann Definieren verschiedener Leistungspegel Pavs1,..., Pavsn des RF-Impulses durch Schneiden der Änderungskurve der gemessenen Amplitude von Vgs in Abhängigkeit von der Leistung Pavs, wobei jeder Leistungspegel Pavs1,..., Pavsn einem bestimmten Bereich der Spannung Vgs entspricht;
e2) für die definierte Lastimpedanz (8), Messen der Spannungsänderungskurve Vgs in Abhängigkeit von der Spannung Vds, um mögliche Wertepaare (N1, N2) zu bestimmen; und
e3) für jedes mögliche Wertepaar (N1, N2), Bestimmen des entsprechenden Leistungspegels NRF, der auf den RF-Vorimpuls (9) angewendet werden soll, aus den verschiedenen Leistungspegeln Pavs1,..., Pavsn.

5. Charakterisierungsverfahren nach einem der Ansprüche 1 bis 4, **dadurch gekennzeichnet, dass** in Schritt b) die Lastimpedanz (8) vom Benutzer in Abhängigkeit von der Endanwendung definiert (S1') wird, wodurch eine Beanspruchung auf das Kompressionsniveau des Transistors (2) definiert (S3') wird.

6. Charakterisierungsverfahren nach einem der Ansprüche 1 bis 4, **dadurch gekennzeichnet, dass** der Schritt des Definierens der Lastimpedanz b) umfasst:

Messen (S31), am Polarisationspunkt, des Konjugats des Ausgangsreflexionskoeffizienten S22 des Transistors (2) bei der Frequenz f0 und Bestimmen einer entsprechenden Anfangs-Lastimpedanz;
Durchführen (S32) einer Messung, die eine Leistungsabtastung mit einer Änderung der Lastimpedanz um die Anfangs-Lastimpedanz kumuliert, um die optimale Lastimpedanz zu bestimmen, bei der die Spannungsabweichung Vds bei einem minimalen Kompressionsniveau maximal ist; und
Definieren der Lastimpedanz (8), derart, dass sie gleich der bestimmten optimalen Lastimpedanz ist.

7. Charakterisierungsverfahren nach einem der Ansprüche 1 bis 6, **dadurch gekennzeichnet, dass** es ferner zwischen den Schritten b) und c) einen Schritt des Bestimmens des zweiten Änderungsgesetzes (S5) umfasst, umfassend:

f1) für mindestens den ersten Zeitraum T, Definieren von V1 = 0 und V2 = 0; und
f2) für jeden der folgenden Zeiträume T, Definieren von V1 und V2, derart, dass N1 und N2 über alle Zeiträume T hinweg um den Polarisationspunkt variieren und sich dabei schrittweise von diesem wegbewegen.

8. Charakterisierungsverfahren nach einem der Ansprüche 1 bis 7, **dadurch gekennzeichnet, dass** es ferner in jedem Zeitraum T das Messen der Parameter S am Gate (2a) und am Drain (2b) des Transistors (2) während des Anlegens des ersten und des zweiten DC-Impulses (10, 11) umfasst.

9. Charakterisierungsverfahren nach einem der Ansprüche 1 bis 8, **dadurch gekennzeichnet, dass** der Schritt c3) ferner umfasst: während der Messdauer TM, Messen der Gate-Spannung, der Drain-Spannung und des Gate-Stroms des Transistors (2).

10. Messbank (1) zur Charakterisierung eines Halbleiter-III-V-Transistors (2) im Impulsmodus, wobei die Messbank (1) einen RF-Impulsgenerator (3), eine erste DC-Impulsspannungsquelle (4), die mit einem ersten Multimeter verbunden ist, das zum Messen von Spannungen und Strömen konfiguriert ist, eine zweite DC-Impulsspannungsquelle (5), die mit einem zweiten Multimeter verbunden ist, das zum Messen von Spannungen und Strömen konfiguriert ist, ein erstes Polarisations-T-Stück (6) und ein zweites Polarisations-T-Stück (7) umfasst, wobei der RF-Impulsgenerator (3) und die erste DC-Impulsspannungsquelle (4) so konfiguriert sind, dass sie über das erste Polarisations-T-Stück (6) mit dem Gate (2a) des Transistors (2) verbunden sind, wobei die zweite DC-Impulsspannungsquelle (5) und eine Lastimpedanz (8) so konfiguriert sind, dass sie über das zweite Polarisations-T-Stück (7) mit dem Drain (2b) des Transistors (2) verbunden sind, wobei die Messbank (1) ferner eine Steuervorrichtung umfasst, die so konfiguriert ist, dass sie den RF-Impulsgenerator (3), die erste DC-Impulsspannungsquelle (4) und die zweite DC-Impulsspannungsquelle (5) steuert, um das Charakterisierungsverfahren nach einem der Ansprüche 1 bis 9 durchzuführen.

11. Messbank (1) nach Anspruch 10, **dadurch gekennzeichnet, dass** sie ferner einen Vektornetzwerkanalysator (12) umfasst, der so konfiguriert ist, dass er über Koppler (13, 14) mit dem Gate (2a) und dem Drain (2b) des Transistors (2) verbunden ist.

12. Messbank (1) nach Anspruch 10 oder 11, **dadurch gekennzeichnet, dass** sie ferner mindestens zwei Wattmeter umfasst, die so konfiguriert sind, dass sie über Koppler mit dem Gate (2a) und dem Drain (2b) des Transistors (2) verbunden sind.

## Claims

1. Method for **characterising in** pulsed mode a III-V semiconductor transistor (2), the transistor (2) comprising a gate (2a), a drain (2b) and a source (2c), wherein said method comprises the following steps:

a) defining (S1; S1') a bias point of the transistor (2) corresponding to a gate-source bias voltage Vgs0 and a drain-source bias voltage Vds0;
b) defining (S3; S1') a load impedance (8) applied to the drain (2b) of the transistor (2);

**characterised in that** said method further comprises the following steps:
c) defining a period T, and for each period T:

- c1) applying a radio frequency, RF, pre-pulse (9) to the gate (2a) of the transistor (2) so as to fix the charge state of the traps in the transistor (2), said RF pre-pulse (9) having a predefined frequency f0, a predefined pre-pulse duration TRF and a power level NRF defined according to a first predetermined variation law;
- c2) after the RF pre-pulse (9), applying a first direct current, DC, pulse (10) to the gate (2a) of the transistor (2) and a second DC pulse (11) to the drain (2b) of the transistor (2), the first DC pulse (10) having a first duration T1 and the second DC pulse (11) having a second duration T2, the first and second durations T1, T2 being at least partially concurrent, the first DC pulse (10) and the second DC pulse (11) having, respectively, a first DC level N1 and a second level DC N2 defined according to a second predetermined variation law; and
- c3) during a measurement time TM while the first and second DC pulses (10, 11) are applied concurrently, measuring (S6) the current Id flowing in the drain (2b) of the transistor (2);

wherein, for each period T, in the first variation law, the power level NRF of the RF pre-pulse (9) depends on the first N1 and second N2 DC levels of the first and second DC pulses (10, 11) subsequently applied in the same period T;

wherein, for each period T, in the second variation law, the first DC level N1 is equal to Vgs0 plus a first value V1 defined by the second variation law according to the present period T, and the second DC level N2 is equal to Vds0 plus a second value V2 defined by the second variation law according to the current period T, the first V1 and second V2 values being real numbers.

2. Characterisation method according to Claim 1, **characterised in that** it further comprises, between steps a) and b), a step (S2) of determining the period T and the durations TRF, T1 and T2 according to the measurement of the time constants of the traps in the transistor (2) on the gate (2a) and on the drain (2b) of the transistor (2).

3. Characterisation method according to Claim 1 or 2, **characterised in that** it further comprises, between steps a) and b):

   d1) defining (S2) the lower and upper limits [Vgsmin; Vgsmax] of the first DC level N1 in the second variation law, where:

   Vgsmax is determined by measuring the gate current Ig of the transistor (2) as a function of the voltage DC Vgs applied to the gate (2a) of the transistor (2) for a zero voltage Vds applied to the drain (2b) of the transistor (2), then by defining Vgsmax as being the value of Vgs for which the gate current Ig reaches a predetermined current threshold value; and
   Vgsmin ≤ Vp where Vp is the pinch-off voltage of the transistor (2); and

   d2) defining (S2) the lower and upper limits [Vdsmin; Vdsmax] of the second DC level N2 in the second variation law, where Vdsmin = 0V and Vdsmax = 2 * Vds0.

4. Characterisation method according to one of Claims 1 to 3, **characterised in that** it further comprises, between steps b) and c), a step of determining the first variation law (S4) comprising:

   e1) for the defined load impedance (8) applied to the drain (2b) of the transistor (2), measuring the amplitude of Vgs over time at f0 or at a harmonic of f0 as a function of the power Pavs emitted in an RF pulse at f0 or at a harmonic of f0, then defining different power levels Pavs1,..., Pavsn of the RF pulse by segmenting the variation curve of the measured amplitude of Vgs as a function of the power Pavs, each power level Pavs1,..., Pavsn corresponding to a certain range of the voltage Vgs;
   e2) for the defined load impedance (8), measuring the variation curve of the voltage Vgs as a function of the voltage Vds so as to determine possible pairs of values (N1, N2); and
   e3) for each possible pair of values (N1, N2), determining the corresponding NRF power level to be applied to the RF pre-pulse (9) among the different power levels Pavs1, ... , Pavsn.

5. Characterisation method according to one of Claims 1 to 4, **characterised in that**, in step b), the load impedance (8) is defined (S1') by the user according to the final application, which defines (S3') a constraint on the compression level of the transistor (2).

6. Characterisation method according to one of Claims 1 to 4, **characterised in that** the step of defining the load impedance b) comprises:

   measuring (S31), at the bias point, the conjugate of the output reflectance coefficient S22 of the transistor (2) at the frequency f0 and determining a corresponding initial load impedance;
   performing (S32) a measurement combining a power sweep with a variation of the load impedance around said initial load impedance in order to determine the optimal load impedance for which the excursion of the voltage Vds is maximal at a minimal compression level; and
   defining the load impedance (8) as being equal to the determined optimal load impedance.

7. Characterisation method according to one of Claims 1 to 6, **characterised in that** it further comprises, between steps b) and c), a step of determining the second variation law (S5) comprising:

   f1) for at least the first period T, defining V1 = 0 and V2 = 0; and

f2) for each of the following periods T, defining V1 and V2 such that, over all the periods T, N1 and N2 vary around the bias point while gradually moving away from it.

8. Characterisation method according to one of Claims 1 to 7, **characterised in that** it further comprises, at each period T, measuring the parameters S on the gate (2a) and the drain (2b) of the transistor (2) while the first and second DC pulses (10, 11) are applied.

9. Characterisation method according to one of Claims 1 to 8, **characterised in that** step c3) further comprises: during the measurement time TM, measuring the gate voltage, the drain voltage and the gate current of the transistor (2).

10. Test bench (1) for **characterising in** pulsed mode a III-V semiconductor transistor (2), the test bench (1) comprising a pulsed RF generator (3), a first pulsed DC voltage source (4) associated with a first multimeter configured to measure voltages and currents, a second pulsed DC voltage source (5) associated with a second multimeter configured to measure voltages and currents, a first bias tee (6) and a second bias tee (7), the pulsed RF generator (3) and the first pulsed DC voltage source (4) being configured to be connected to the gate (2a) of the transistor (2) via the first bias tee (6), the second pulsed DC voltage source (5) and a load impedance (8) being configured to be connected to the drain (2b) of the transistor (2) via the second bias tee (7), the test bench (1) further comprising a control device configured to control the pulsed RF generator (3), the first pulsed DC voltage source (4) and the second pulsed DC voltage source (5) so as to perform the characterisation method according to one of Claims 1 to 9.

11. Test bench (1) according to Claim 10, **characterised in that** it further comprises a vector network analyser (12) configured to be connected to the gate (2a) and to the drain (2b) of the transistor (2) via couplers (13, 14).

12. Test bench (1) according to Claim 10 or 11, **characterised in that** it further comprises at least two wattmeters configured to be connected to the gate (2a) and to the drain (2b) of the transistor (2) via couplers.

[Fig. 1]

Fig.1

[Fig. 2]

Fig.2

[Fig. 3]

Fig.3

[Fig. 4]

EP 4 416 515 B1

Fig.4

[Fig. 5]

S1 — Définition de (Vgs0, Vds0)

S2 — Détermination de T, TRF, T1 et T2, et définition des bornes de N1 et N2

S31 — Mesure du S22* à $f_0$

S3

S32 — Détermination de Zload, opt: compromis niveau de compression min et amplitude de V2 max

S4 — Détermination de la première loi de variation

S5 — Détermination de la seconde loi de variation

S6 — Mesure du réseau I-V tenant compte de la variation dynamique de l'état de charge des pièges.

Fig.5

[Fig. 6]

Fig.6

[Fig. 7]

Fig.7

[Fig. 8]

Fig.8

[Fig. 9]

Fig.9

[Fig. 10]

Fig.10

[Fig. 11]

Fig.11

[Fig. 12]

Fig.12

[Fig. 13]

S1' → Définition de (Vgs0, Vds0) et $Z_{LOAD}$

S2 → Détermination de T, TRF, T1 et T2,
et définition des bornes de N1 et N2

S3' → Détermination du niveau de
compression selon $Z_{LOAD}$

S4 → Détermination de la première
loi de variation

S5 → Détermination de la seconde
loi de variation

S6 → Mesure du réseau I-V tenant
compte de la variation dynamique
de l'état de charge des pièges.

Fig.13

[Fig. 14]

Fig.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Caractérisation I-V et RF pulsée et modélisation des HEMTs AIGaN et des FETs en graphène. Poornakarthik Nakkala. Electronics. Université de Limoges, 2015, 1-191
- **G. P. GIBIINO et al.** 21st International Conference on Microwave. *Radar and Wireless Communications (MIKON)*, 2016, 1-4

- **G. P. GIBIINO** ; **C. FLORIAN** ; **A. SANTARELLI** ; **T. CAPPELLO** ; **Z. POPOVIÉ**. *IEEE Microwave and Wireless Components Letters*, August 2018, vol. 28 (8), 672-674